# EUROPEAN PATENT APPLICATION

(11) **EP 4 821 338 A1**
(43) Date of publication of application: **14.10.2026**
(21) Application number: 24914634.1
(22) Date of filing: 04.01.2024
(51) Int. Cl.: A01D 34/00

(54) **MOWING ROBOT**

(71) Applicant: Aiper Global Pte. Ltd., Singapore 409051 (SG)
(72) Inventor: WANG, Yang, Shenzhen, Guangdong 518000 (CN)
(74) Representative: Osterhoff, Utz
(86) International application number: PCT/CN2024/070690
(87) International publication number: WO 2025/145404

(57) **Abstract**

A mowing robot (10), including: a housing including a first housing (21) and a second housing (11) connected to the first housing (21), the second housing (11) and the first housing (21) are vertically distributed; an actuator, disposed on the first housing (21), configured to perform operations including driving the housing to move and performing cutting; a control module (12), disposed on the second housing (11) and electrically connected to the actuator, configured to control the actuator to perform the operations. The mowing robot (10) separates the housing into the second housing (11) and the first housing (21) which are independent of each other, with the actuator disposed on the first housing (21) and the control module (12) disposed on the second housing (11), to isolate the two heat sources, namely the actuator and the control module (12), thereby reducing, through physical isolation, the influence of heat generated by the actuator on the heat dissipation of the control module (12), and suppressing temperature rise of the control module (12).

## Description

### TECHNICAL FIELD

The present application relates to the technical field of lawn mowing equipments, and in particular to a mowing robot.

### BACKGROUND

A lawn mower, as a device for trimming lawns, brings convenience to lawn maintenance. In the related art, a mounting chamber is provided at the body of the lawn mower, and components such as a control circuit board and a motor are all installed in the mounting chamber. During operations of the lawn mower, these components generate heat. Particularly for an intelligent mowing robot, since the intelligent mowing robot has the capability of autonomous movement, the control circuit board handles a large amount of computation, which causes the control circuit board to generate significant heat and reach high temperatures. For this reason, temperature control of the control circuit board has become an urgent technical problem to be solved.

### SUMMARY

The main purpose of the present application is to provide a mowing robot and a mowing system, aiming to solve the technical problem in the related art that the control module and the actuator are disposed in the same mounting chamber, resulting in poor heat dissipation.

To achieve the above purpose, a first aspect of the present application provides a robot mower, including: a housing including a first housing and a second housing connected to the first housing, wherein the second housing and the first housing are vertically distributed; an actuator provided at the first housing and configured to perform operations, the operations including driving the housing to move and performing cutting; and a control module provided at the second housing and electrically connected to the actuator, the control module being configured to control the actuator to perform the operations.

The beneficial effects of the mowing robot provided by the present application at least include: by dividing the housing into the second housing and the first housing that are independent of each other, with the actuator disposed on the first housing and the control module disposed on the second housing, the two heat sources, namely the actuator and the control module, are isolated from each other; through physical isolation, the influence of heat generated by the actuator on the heat dissipation of the control module is reduced, thereby suppressing temperature rise of the control module.

### BRIEF DESCRIPTION OF THE DRAWINGS

To more clearly illustrate technical solutions in the embodiments of the present application, the following will briefly introduce the drawings that need to be used in the description of the embodiments or the related art. Obviously, the drawings in the following description are only some embodiments of the present application. For those skilled in the art, without creative effort, other drawings can be obtained according to the structures shown in these drawings.
FIG. 1 is a schematic structural diagram of a mowing robot according to an embodiment of the present application.
FIG. 2 is a schematic structural diagram of the mowing robot according to an embodiment of the present application when the second housing is separated from the first housing.
FIG. 3 is a side view of the mowing robot in FIG. 2.
FIG. 4 is a schematic structural diagram of the second housing installed with a decorative housing according to an embodiment of the present application.
FIG. 5 is a bottom view of the second housing according to an embodiment of the present application.
FIG. 6 is a schematic structural diagram of the second housing without installing an upper housing and a decorative housing according to an embodiment of the present application.
FIG. 7 is a schematic diagram of installation of the control module according to an embodiment of the present application.
FIG. 8 is another schematic structural diagram of the second housing without installing an upper housing according to an embodiment of the present application.
FIG. 9 is a schematic structural diagram of a bottom housing of the second housing according to an embodiment of the present application.
FIG. 10 is a schematic structural diagram of a channel structure of the bottom housing in FIG. 9 after a heat dissipation board is provided at the channel structure.
FIG. 11 is a schematic structural diagram of the second housing without a decorative housing and a button module according to an embodiment of the present application.
FIG. 12 is a schematic structural diagram of a camera module according to an embodiment of the present application.
FIG. 13 is a schematic structural diagram of the camera module in FIG. 12 without an image pre-processing board and a heat sink.
FIG. 14 is a schematic structural diagram of the camera module in FIG. 12 without a heat sink.
FIG. 15 is a schematic structural diagram of the camera module installed on a front housing according to an embodiment of the present application.
FIG. 16 is a schematic structural diagram of the front housing according to an embodiment of the present application.
FIG. 17 is a top view of a button module according to an embodiment of the present application.
FIG. 18 is a bottom view of the button module according to an embodiment of the present application.
FIG. 19 is a schematic structural diagram of an emergency stop button according to an embodiment of the present application.
FIG. 20 is a schematic structural diagram of the first housing according to an embodiment of the present application.
FIG. 21 is a schematic structural diagram of a chassis in the first housing according to an embodiment of the present application.
FIG. 22 is a top view of a cover body in the first housing according to an embodiment of the present application.
FIG. 23 is a bottom view of the cover body in the first housing according to an embodiment of the present application.
FIG. 24 is a schematic structural diagram of the chassis in the first housing according to an embodiment of the present application.
FIG. 25 is a schematic structural diagram of the first housing without the cover body according to an embodiment of the present application.
FIG. 26 is a bottom view of a cutting mechanism provided at the first housing according to an embodiment of the present application.
FIG. 27 is a bottom view of the cutting mechanism according to an embodiment of the present application.
FIG. 28 is a schematic structural diagram of the cutting mechanism according to an embodiment of the present application.
FIG. 29 is a schematic structural diagram of a height adjustment device provided at the chassis according to an embodiment of the present application.
FIG. 30 is a schematic structural diagram of the height adjustment device according to an embodiment of the present application.
FIG. 31 is a schematic structural diagram of a driven wheel module according to an embodiment of the present application.
FIG. 32 is a schematic structural diagram of the interior of the driven wheel module according to an embodiment of the present application.
FIG. 33 is a schematic structural diagram of a driving wheel module according to an embodiment of the present application.
FIG. 34 is a schematic structural diagram of a travelling motor according to an embodiment of the present application.
FIG. 35 is a schematic structural diagram of a first wheel body according to an embodiment of the present application.
FIG. 36 is a schematic structural diagram of a collision module according to an embodiment of the present application.
FIG. 37 is a schematic structural diagram of the collision module in FIG. 36 from another perspective.
FIG. 38 is a schematic structural diagram of a support portion according to an embodiment of the present application.
FIG. 39 is an exploded view of a collision body according to an embodiment of the present application.
FIG. 40 is a schematic structural diagram of a charger plug according to an embodiment of the present application.
FIG. 41 is a schematic structural diagram of a base station according to an embodiment of the present application.

Description of reference numbers:
10, mowing robot; 11, second housing; 111, upper housing; 1111, second mounting opening; 1112, communication opening; 112, bottom housing; 1121, first mounting opening; 1122, rear housing; 1123, air guiding window; 113, decorative housing; 114, front housing; 1141, window opening; 12, control module; 121, connecting post; 122, base board; 123, core board; 13, heat dissipation structure; 131, channel structure; 132, channel chamber; 133, opening; 134, heat dissipation board; 135, air inlet; 136, air outlet; 137, fan; 138, filter screen; 139, heat transfer block; 14, communication module; 141, communication antenna; 142, communication control board; 15, camera module; 151, base body; 152, front end portion; 153, rear end portion; 154, accommodating chamber; 155, lens; 156, camera group; 157, image pre-processing board; 158, heat sink; 16, button module; 161, button housing; 162, button circuit board; 163, button switch; 164, emergency stop button; 165, third detection portion; 166, third trigger portion; 167, elastic piece; 17, first positioning module; 171, positioning antenna; 172, positioning chip; 18, handle; 21, first housing; 211, chassis; 212, cover body; 2121, high-voltage wire through hole; 2122, low-voltage wire through hole; 22, cutting mechanism; 221, cutting motor; 222, blade disc; 223, blade; 225, mounting groove; 226, connecting seat; 227, first mounting seat; 23, height adjustment device; 231, height adjustment motor; 232, transmission assembly; 233, second mounting seat; 234, swing arm; 235, screw rod; 236, gear; 24, height detection mechanism; 241, first detection portion; 242, first trigger portion; 25, driven wheel module; 251, second wheel body; 252, conductive block; 253, elastic electrode piece; 254, second mounting compartment; 255, mounting arm; 256, fourth through-hole; 257, first end; 258, second end; 26, driving wheel module; 261, travelling motor; 262, first wheel body; 263, first mounting compartment; 264, third through-hole; 265, first connecting lug; 266, first connecting portion; 27, collision module; 271, support portion; 272, detection element; 273, movable cover body; 274, receiving chamber; 275, elastic member; 276, trigger element; 28, battery compartment; 281, charger plug; 282, charging electrode; 31, charging pile; 41, base station; 411, second positioning module.

### DETAILED DESCRIPTION OF THE EMBODIMENTS

In order to make the technical problem to be solved, the technical solution, and the beneficial effects of the present application more clearly understood, the present application is further described in detail below with reference to the accompanying drawings and embodiments. It should be understood that the specific embodiments described herein are merely for illustrating the present application and are not intended to limit the present application.

It should be noted that when a component is referred to as being "fixed to" or "disposed on" another component, it may be directly or indirectly located on that other component. When a component is referred to as being "connected to" another component, it may be directly or indirectly connected to that other component. The terms "upper", "lower", "left", "right", "front", "rear", "vertical", "horizontal", "top", "bottom", "inner", "outer", and the like indicating orientation or positional relationships are based on the orientations or positions shown in the drawings, and are merely for convenience of description and should not be construed as limiting the technical solution. The terms "first" and "second" are used merely for convenience of description and should not be construed as indicating or implying relative importance or implicitly indicating the number of technical features. The term "plurality" means two or more, unless otherwise expressly and specifically defined.

According to a first aspect of the embodiments of the present application, a mowing robot is provided. The mowing robot in the embodiments of the present application is described below with reference to the accompanying drawings.

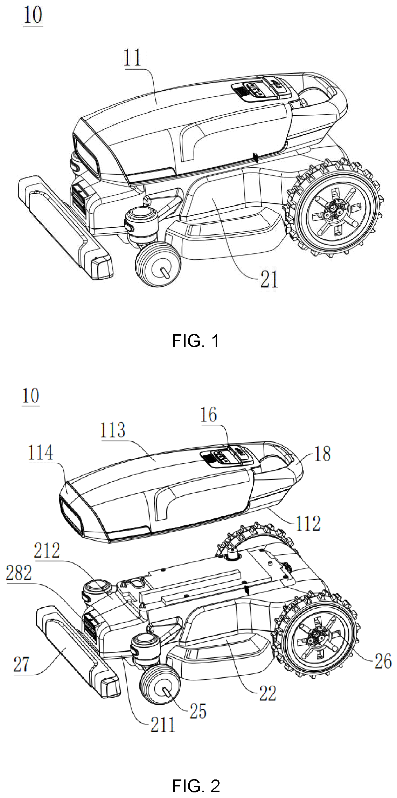

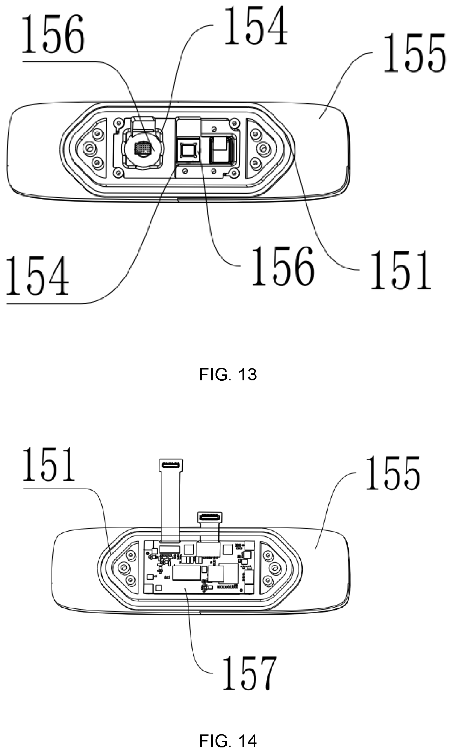

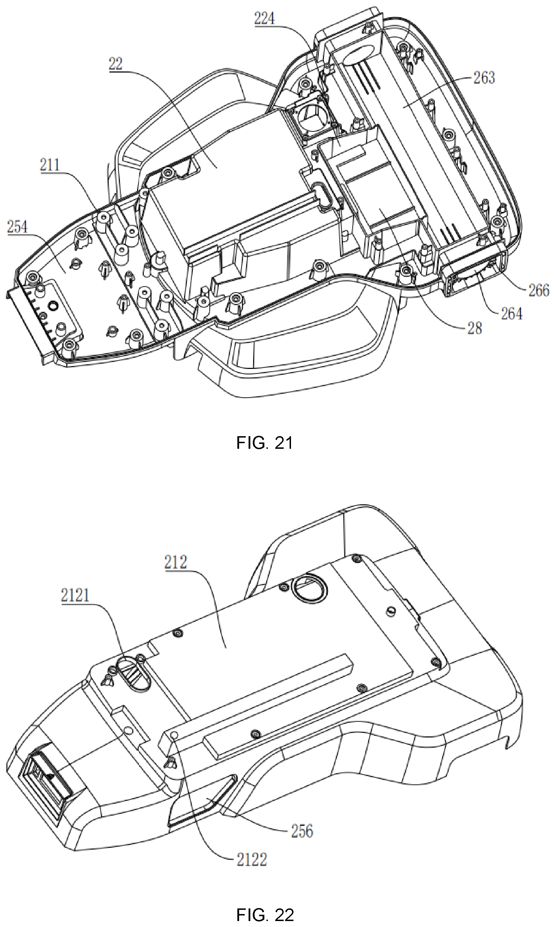

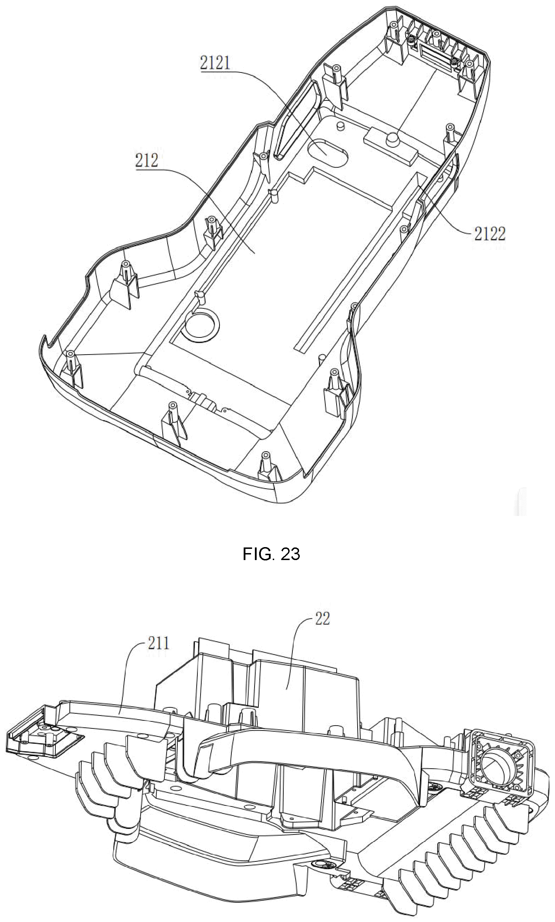

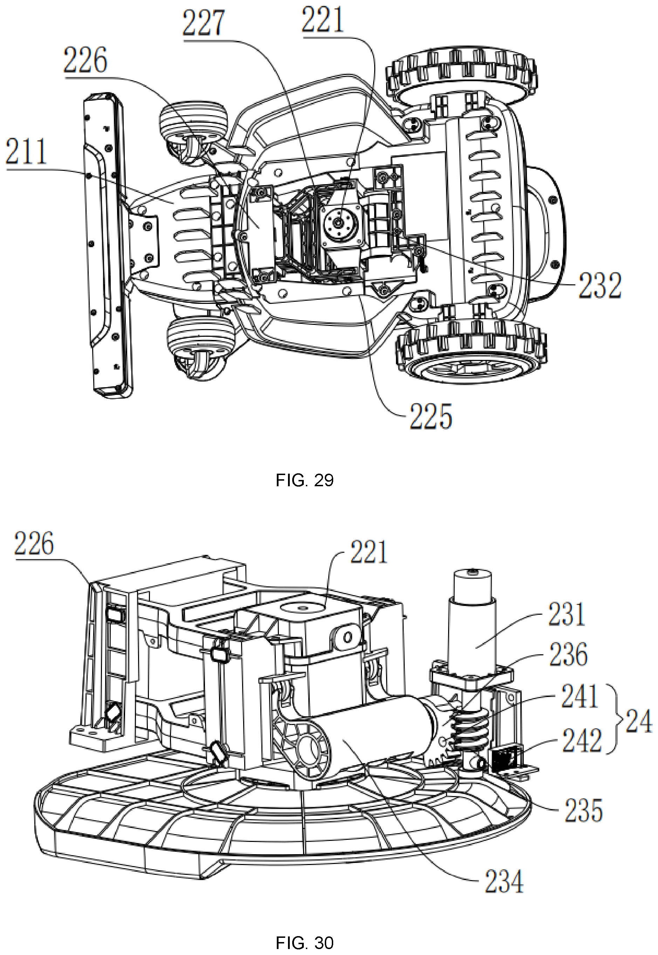

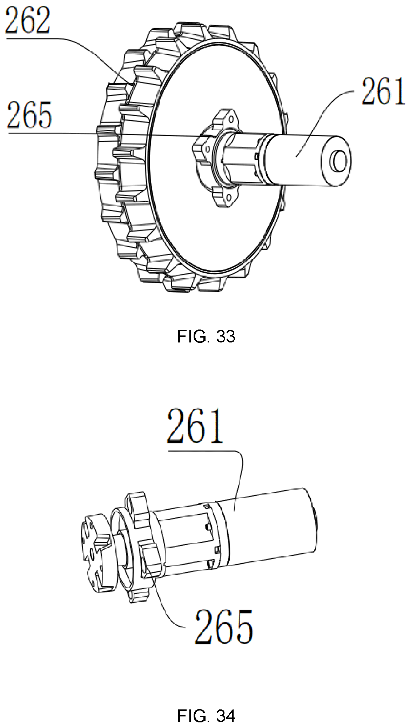

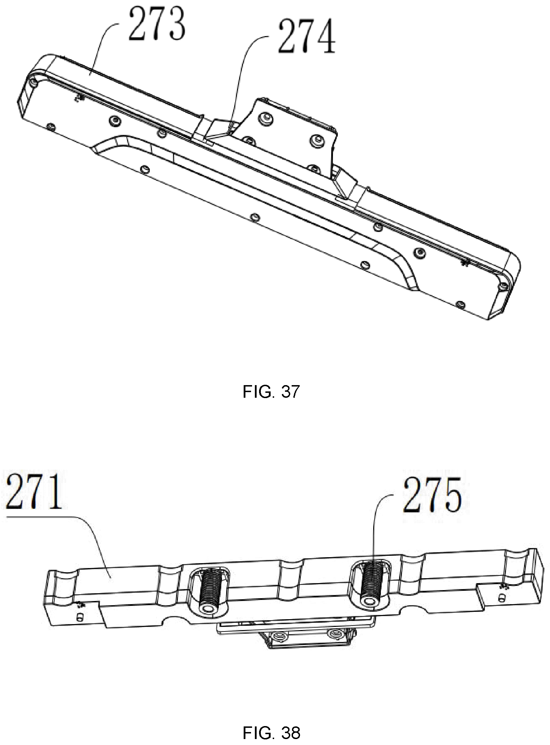

Please refer to FIG. 1 to FIG. 40, which show schematic structural views of the overall mowing robot 10 and the structures of various parts of the mowing robot 10. The mowing robot 10 includes a housing, an actuator, and a control module 12.

As shown in FIG. 1 to FIG. 3, the housing is divided into two parts, including a first housing 21 and a second housing 11 connected to the first housing 21. The second housing 11 and the first housing 21 are vertically distributed. The actuator is disposed on the first housing 21 and is configured to perform operations, the operations including driving the housing to move and perform cutting. The control module 12 is disposed on the second housing 11 and is electrically connected to the actuator, and is configured to control the actuator to perform the operations.

It can be understood that after the first housing 21 and the second housing 11 are connected to form the housing, the mounting spaces of the first housing 21 and the second housing 11 are separated from each other, forming physical isolation.

Different from the conventional technology in which the actuator and the control module 12 are provided in the same area, the present application improves the housing structure by dividing the housing into the second housing 11 and the first housing 21 that are independent of each other. The actuator is disposed on the first housing 21, and the control module 12 is disposed on the second housing 11, so as to isolate the two heat sources, namely the actuator and the circuit structure. It can be understood that the actuator is a device for performing operations, and includes components that easily generate heat, such as motors and sensors. When the mowing robot 10 is working, the heat emitted by the motors and sensors in the actuator on the first housing 21 is isolated by the first housing 21 and the second housing 11. Through physical isolation, the influence of the heat generated by the actuator on the heat dissipation of the control module 12 is reduced, and the temperature rise of the control module 12 is suppressed. In addition, the second housing 11 can also dissipate heat from the control module 12 through the heat dissipation structure 13, reducing the risk of excessive temperature of the control module 12.

Moreover, when maintaining the actuator and the control module 12, the corresponding second housing 11 and first housing 21 can be separately assembled and disassembled, making maintenance more convenient.

When sealing is required, the separately provided second housing 11 and first housing 21 can separately seal the actuator and the control module 12. For example, when the sealing of the first housing 21 is compromised, the second housing 11 can still remain sealed, and the control module 12 can still operate normally. In the conventional technology, where the actuator and the control module 12 are provided in the same area and then sealed as a whole, once the sealing is broken, both the actuator and the control module 12 are affected. This separate sealing approach provides better protection compared to integral sealing.

In use, the bottom of the first housing 21 is close to the ground, and the second housing 11 is located above the first housing 21, at a relatively higher position. This reduces the probability of contact between the second housing 11 and green plants or grass, preventing dew, rain, or the like on the grass from wetting the second housing 11. By disposing the control module 12 on the second housing 11, the isolation and blocking effect of the first housing 21 can reduce the influence of moisture on the control module 12.

In an embodiment, the first housing 21 and the second housing 11 may be detachably connected by screwing. For example, mounting holes are provided at the second housing 11 and the first housing 21. After the second housing 11 and the first housing 21 are aligned in position, bolts are screwed into the mounting holes to fix the second housing 11 and the first housing 21. By unscrewing the bolts, the second housing 11 and the first housing 21 can be separated. Certainly, the second housing 11 and the first housing 21 may also be detachably connected by snap-fitting. The specific connection manner is not particularly limited in the present application, and any manner that enables detachable connection may serve as a technical solution for connecting the second housing 11 and the first housing 21.

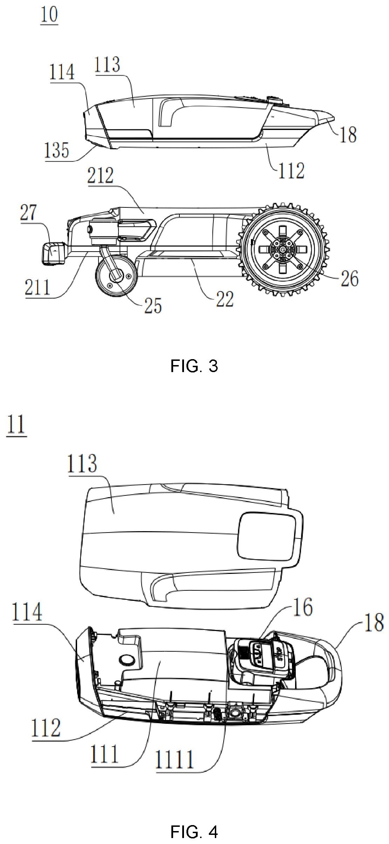

As shown in FIG. 4 to FIG. 11, a heat dissipation structure 13 is provided at the second housing 11, and the heat dissipation structure 13 is used to dissipate heat from the control module 12.

In some embodiments, as shown in FIG. 4 to FIG. 5, the second housing 11 includes an upper housing 111 and a bottom housing 112. The upper housing 111 is fixed to the bottom housing 112, and the connection manner may be screwing or snap-fitting, facilitating subsequent disassembly and maintenance. At least one of the upper housing 111 and the bottom housing 112 has a recessed cavity. After the upper housing 111 is mounted to the bottom housing 112, the upper housing 111 and the bottom housing 112 together define a sealed chamber. Still as shown in FIG. 4 to FIG. 5, the upper housing 111 has a deep recessed cavity, and the bottom housing 112 has a shallow recessed cavity. After the upper housing 111 is snap-fitted onto the bottom housing 112, the deep recessed cavity is abutted against the shallow recessed cavity to form the sealed chamber. The sealed chamber provides a mounting space, and the control module 12 is disposed within the sealed chamber to reduce external moisture and debris from interfering with the control module 12.

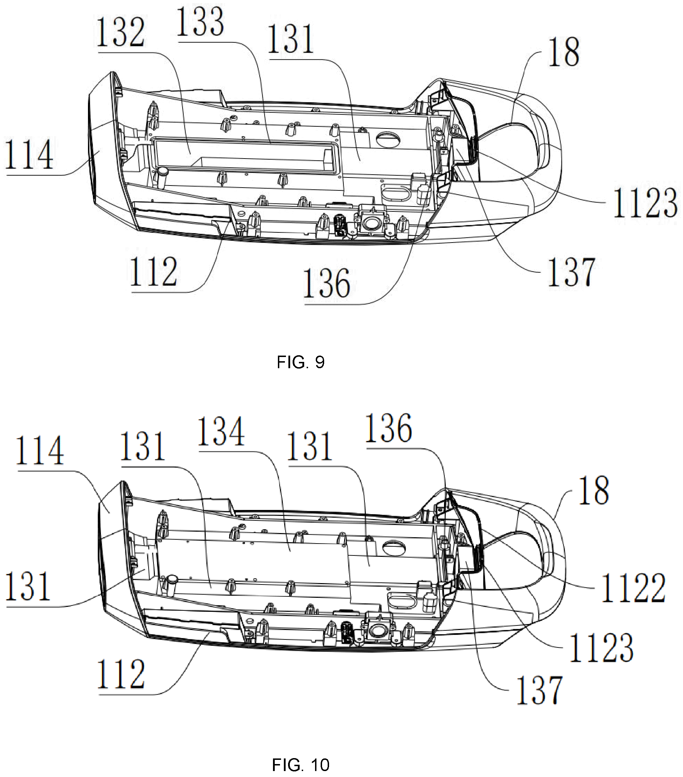

In an embodiment, as shown in FIG. 9 to FIG. 10, the heat dissipation structure 13 includes a channel structure 131 provided at the bottom housing 112. The channel structure 131 is independent of the sealed chamber. The control module 12 is disposed within the sealed chamber and is provided outside the channel structure 131; the control module 12 abuts against a sidewall of the channel structure 131.

The channel structure 131 is a ventilation channel. When the mowing robot 10 is moving, flowing air is formed in the channel structure 131. During air flow, heat exchange with the sealed chamber can occur, carrying away a portion of the heat in the sealed chamber to achieve cooling. The control module 12 abuts against the channel structure 131, with a small gap between the control module 12 and the channel structure 131, so that the heat exchange efficiency between the airflow in the channel structure 131 and the control module 12 is higher, improving the heat dissipation efficiency of the channel structure 131 for the control module 12.

It should be noted that the term "abut" in the above embodiments means that the control module 12 directly or indirectly contacts the sidewall of the channel structure 131, or that the control module 12 is provided in a region close to the channel structure 131. That is, the control module 12 may directly contact the channel structure 131, or may contact the channel structure 131 through other media, or the control module 12 may be close to the channel structure 131 with a gap close to zero, aiming to make the control module 12 close to or contact with the channel structure 131 to improve heat exchange efficiency between the control module 12 and the channel structure 131.

In the following embodiments, when it is described that a certain component abuts against another component, it means that the certain component directly or indirectly contacts the other component, or that the certain component is provided in a region close to the other component.

In an embodiment, as shown in FIG. 10, the heat dissipation structure 13 further includes a heat dissipation board 134 provided at the bottom housing 112. The heat dissipation board 134 constitutes a portion of the sidewall of the channel structure 13, and the control module 12 abuts against the heat dissipation board 134. The heat dissipation board 134 is a board having good thermal conductivity. An aluminum alloy board may be selected for higher heat transfer efficiency. The control module 12 abuts against the heat dissipation board 134, so that the heat generated by the control module 12 can be quickly transferred to the channel structure 131 through the heat dissipation board 134, thereby dissipating heat from the control module 12 more efficiently.

Obviously, the channel structure 131 is a channel structure similar to a pipe, and is independent of the sealed chamber. That is, the channel structure 131 penetrates the sealed chamber, but the flowing air in the channel structure 131 does not exchange with the air in the sealed chamber, so the airflow in the channel structure 131 does not affect the components in the sealed chamber, ensuring the sealing of the sealed chamber.

In some embodiments, as shown in FIG. 9, the channel structure 131 is provided with a channel chamber 132 for air flow. The channel chamber 132 may be integrally formed on the bottom housing 112, or may be detachably connected to the bottom housing 112 by screwing or other means. The channel structure 131 is provided with a first through hole 133 communicating with the channel chamber 132 along the extension direction of the channel structure 131. The first through hole 133 is blocked by the heat dissipation board 134, so that the channel chamber 132 is independent of the sealed chamber. With this arrangement, a strip-shaped heat dissipation board 134 is formed on the sealed channel structure 131, and the inner side of the heat dissipation board 134 is in direct contact with the airflow in the channel chamber 132, while the outer side of the heat dissipation board 134 is exposed to the outside of the channel structure 131 without any other medium between the the outer side of the heat dissipation board 134 and the outside of the channel structure 131, ensuring heat transfer efficiency.

Moreover, the heat dissipation board 134 is a strip-shaped board provided along the extension direction of the channel structure 131, so that the airflow throughout the channel structure 131 can exchange heat with the heat in the sealed chamber through the heat dissipation board 134, further improving the heat dissipation effect on the sealed chamber.

To further improve heat dissipation efficiency, heat dissipation fins are provided at the inner side of the heat dissipation board 134, while the outer side of the heat dissipation board 134 is planar, and the control module 12 abuts against the outer side of the heat dissipation board 134. The heat dissipation fins on the inner side of the heat dissipation board 134 extend into the channel structure 131, increasing the contact area between the airflow in the channel structure 131 and the heat dissipation board 134, thereby improving heat exchange efficiency and heat dissipation.

In some embodiments, to further enhance the heat dissipation effect, a fan 137 is provided inside the channel structure 131. The fan 137 is used to regulate the air flow rate in the channel structure 131. The fan 137 can accelerate the flow of air in the channel structure 131 and accelerate heat exchange efficiency, thereby improving the heat dissipation effect.

In an embodiment, two ends of the channel structure 131 respectively define an air inlet 135 and an air outlet 136. The air inlet 135 and the air outlet 136 are respectively located at two ends of the bottom housing 112. A filter screen 138 is provided at each of the air inlet 135 and the air outlet 136. In an embodiment, a direction from the air inlet 135 to the air outlet 136 corresponds to a traveling direction of the mowing robot 10. In order to prevent debris, such as fallen leaves, from being drawn into the channel structure 131, or to prevent insects, such as cockroaches, from entering a heat dissipation air duct and affecting a fan 137, the filter screen 138 is provided at each of the air inlet 135 and the air outlet 136.

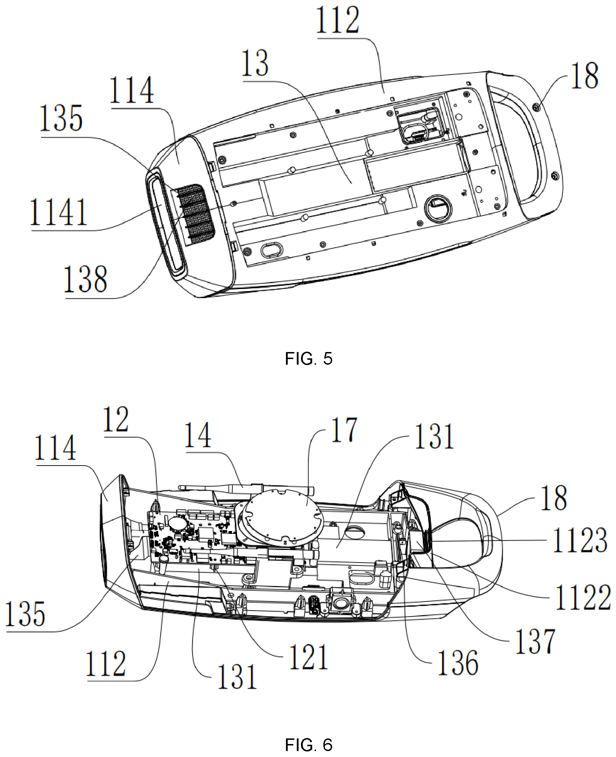

In some embodiments, as shown in FIG. 6 to FIG. 8, the control module 12 is fixed to the bottom housing 112 through a connecting post 121 and provided within the sealed chamber. The control module 12 is positioned above the heat dissipation board 134 and spans across the channel structure 131. At least a portion of the control module 12 is in contact with the heat dissipation board 134 through a heat transfer block 139. The heat transfer block 139 is disposed between the control module 12 and the heat dissipation board 134 as a heat transfer medium to compensate for a distance between the the control module 12 and the heat dissipation board 134. Heat generated by the control module 12 can be transferred to the heat dissipation board 134 through the heat transfer block 139 and then dissipated.

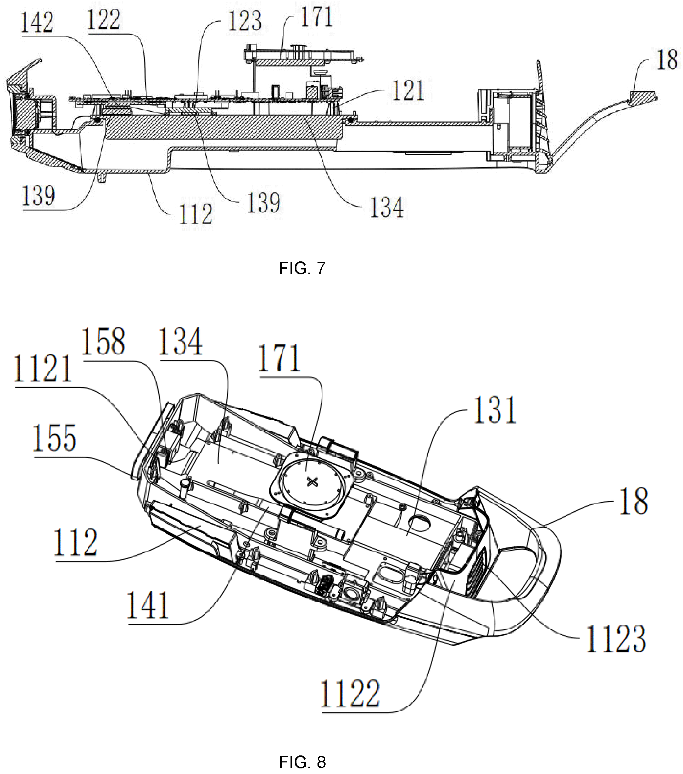

In an embodiment, as shown in FIG. 7, the control module 12 includes a base board 122 and a core board 123. The base board 122 is fixed to the bottom housing 112 and is located above the heat dissipation board 134. The core board 123 is disposed on one side of the base board 122 and is located between the base board 122 and the heat dissipation board 134. The core board 123 is in contact with the heat dissipation board 134.

The heat transfer block 139 is disposed between the core board 123 and the heat dissipation board 134. The heat transfer block 139 is bonded to the core board 123 through a first heat transfer adhesive layer, and the heat transfer block 139 is bonded to the heat dissipation board 134 through a second heat transfer adhesive layer.

The base board 122 is a circuit board. The core board 123 includes an artificial intelligence (AI) chip. The base board 122 and the bottom housing 112 are connected through the connecting post 121 to define an installation gap. The core board 123 is provided within the installation gap and is fixed to the base board 122. The heat transfer block 139 is bonded to the core board 123. Since the mowing robot 10 is an intelligent robot, the AI chip on the core board 123 performs a large amount of computation and is the region most susceptible to heat generation on the circuit board. The AI chip is also the component whose temperature most directly affects a performance of the mowing robot 10. Therefore, by setting that the heat transfer block 139 is bonded to the core board 123 through a heat-conductive adhesive, heat can be rapidly transferred from the core board 123 to the heat dissipation board 134, thereby specifically improving a heat dissipation efficiency of the core board 123.

In some embodiments, the mowing robot 10 further includes a communication module 14 disposed within the sealed chamber. The communication module 14 includes a communication antenna 141 and a communication control board 142. In an embodiment, the communication antenna 141 is a wireless fidelity (Wi-Fi) antenna, and the communication control board 142 is a Wi-Fi board configured to control signal transmission and reception of the Wi-Fi antenna. A communication chip is disposed on the communication control board 142, and the communication chip may be a Wi-Fi chip. The communication antenna 141 is supported on the bottom housing 112 through a mounting post. The communication control board 142 is fixed to the base board 122 and abuts against the heat dissipation board 134. The communication chip is electrically connected to the communication antenna 141.

During operation of the mowing robot 10, the Wi-Fi chip on the communication control board 142 performs a large amount of computation when the communication module 14 transmits and receives signals, such that the Wi-Fi chip on the communication control board 142 generates a relatively large amount of heat and requires heat dissipation. Accordingly, the communication control board 142 is fixed to the base board 122 and abuts against the heat dissipation board 134. The communication control board 142 abuts against the heat dissipation board 134 in the same manner as the control module 12, thereby enabling heat exchange with an airflow within the channel structure 131 and achieving heat dissipation of the communication control board 142.

In an embodiment, as shown in FIG. 4, the second housing 11 further includes a decorative housing 113. The decorative housing 113 covers the upper housing 111 and is fixed to the bottom housing 112. The decorative housing 113, the upper housing 111, and the bottom housing 112 are enclosed to form a thermal insulation chamber surrounding the sealed chamber and positioned above the sealed chamber. The thermal insulation chamber is independent of the sealed chamber.

Since the mowing robot 10 operates outdoors, sunlight directly irradiates an upper portion of the mowing robot 10, thereby increasing a temperature of the upper portion of the mowing robot 10. The decorative housing 113 is exposed on the upper portion of the mowing robot 10 and can provide both a decorative effect and a thermal insulation effect. Specifically, the decorative housing 113 blocks direct sunlight from irradiating the upper housing 111. Through isolation provided by the thermal insulation chamber, an influence of sunlight on an internal temperature of the sealed chamber can be reduced, thereby preventing an excessively high temperature of the control module 12 and other components within the sealed chamber. In addition, the decorative housing 113 can also serve as a rain shield.

In an embodiment, the mowing robot 10 is further provided with a programming interface electrically connected to the control module 12. The programming interface is disposed within the thermal insulation chamber. Accordingly, when firmware upgrading is required, the decorative housing 113 can be opened to expose the programming interface, thereby improving convenience and appearance while reducing corrosion of the programming interface caused by rainwater and the like.

In addition, the mowing robot 10 may further include a lamp board and a speaker electrically connected to the control module 12. The lamp board and the speaker can provide a reminder function during use. The lamp board and the speaker are accommodated within the thermal insulation chamber, thereby providing a cleaner appearance for the mowing robot 10.

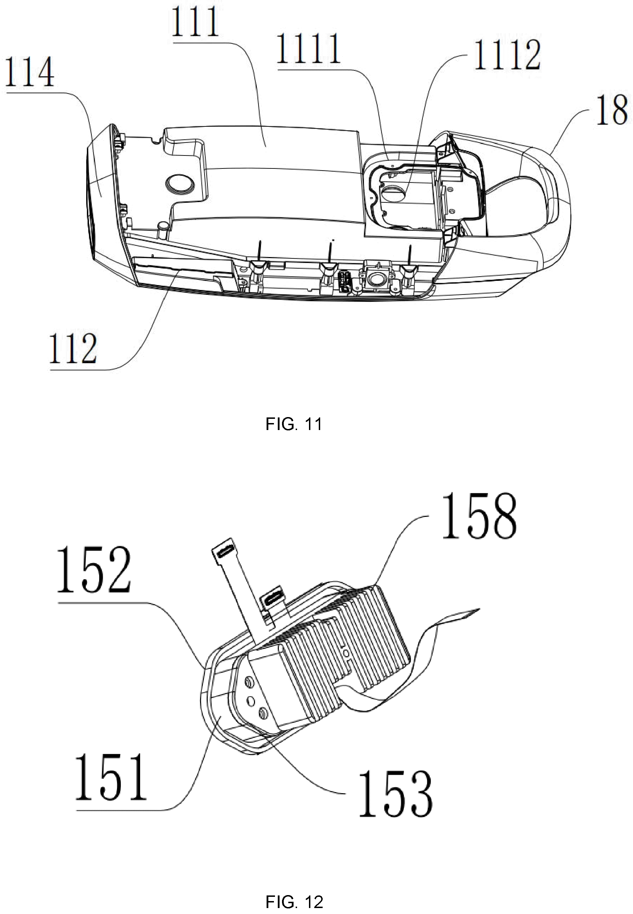

In some embodiments, as shown in FIG. 12 to FIG. 15, the bottom housing 112 is provided with a first mounting opening 1121 communicating with the sealed chamber. A camera module 15 is disposed on the bottom housing 112. The camera module 15 is mounted on the second housing 11 and is located at a relatively high position, thereby providing a wider field of view. Low obstacles are less likely to block the camera module 15, enabling improved obstacle recognition.

In an embodiment, the camera module 15 includes a base body 151, a lens 155, a camera group 156, an image pre-processing board 157, and a heat sink 158. The base body 151 includes a front end portion 152, a rear end portion 153, and an accommodating chamber 154. The accommodating chamber 154 extends through the front end portion 152 and the rear end portion 153. The base body 151 extends into the sealed chamber through the first mounting opening 1121. The front end portion 152 abuts against a surface of a side of the bottom housing 112 away from the sealed chamber. The rear end portion 153 is provided within the sealed chamber and is connected to the bottom housing 112. The lens 155 is mounted on the front end portion 152 of the base body 151 and covers the accommodating chamber 154. The camera group 156 is electrically connected to the image pre-processing board 157. At least a portion of the camera group 156 is disposed within the accommodating chamber 154. The image pre-processing board 157 is configured to perform image pre-processing on images captured by the camera group 156. The image pre-processing includes image decryption and image resizing. The heat sink 158 is mounted on the rear end portion 153 of the base body 151 and abuts against the image pre-processing board 157. At least a portion of the heat sink 158 is provided within the sealed chamber.

In an embodiment, the camera group 156 includes a time of flight (TOF) camera and an red green blue (RGB) camera. The accommodating chamber 154 includes a TOF mounting position and an RGB mounting position arranged side by side. The TOF camera and the RGB camera are respectively mounted at the corresponding mounting positions and are fixed by a pressing block. The pressing block is made of an aluminum alloy material having good thermal conductivity and can also provide a heat dissipation function. The image pre-processing board 157 is electrically connected to the TOF camera and the RGB camera. The image pre-processing board 157 is disposed outside the accommodating chamber 154 and is located on a side of the pressing block away from the TOF camera and the RGB camera. The image pre-processing board 157 is positioned adjacent to the heat sink 158, and the heat sink 158 dissipates heat from the image pre-processing board 157.

In an embodiment, a wire-passing hole is provided in the heat sink 158. A wire connected to the image pre-processing board 157 extends out of the accommodating chamber 154 through the wire-passing hole and is connected to the control module 12, such that the control module 12 can control the camera module 15.

A portion of the camera module 15 is located inside the sealed chamber, while another portion thereof is located outside the sealed chamber. In an embodiment, a portion of the base body 151 is clamped within the first mounting opening 1121 of the bottom housing 112. The heat sink 158 and a portion of the base body 151 are provided within the sealed chamber, while the lens 155 and another portion of the base body 151 are located outside the sealed chamber, thereby reducing influences from moisture and the like.

As shown in FIG. 12 to FIG. 14, the bottom housing 112 includes an upright surrounding edge and a mounting tab. The mounting tab is spaced apart from the surrounding edge. The base body 151 includes an integrally formed first step and an integrally formed second step. In a projection along an axial direction of the base body 151, a projection of the second step is located within a projection of the first step. The second step is stacked on the first step. The heat sink 158 is mounted on the second step. The first mounting opening 1121 is formed in the surrounding edge and is adapted to the second step of the base body 151.

During installation, the second step of the base body 151 and the heat sink 158 extend through the first mounting opening 1121 into the bottom housing 112 and reach the sealed chamber. The second step and the heat sink 158 are blocked by the mounting tab and are fixed to the mounting tab by screws. Heat dissipation fins are provided at the heat sink 158 and are located between two mounting tabs. The bottom housing 112 is further provided with a limiting tab configured to support the surrounding edge, thereby improving a strength of the surrounding edge. The first step of the base body 151 abuts against the surrounding edge. A circumferential groove is formed in the surrounding edge, and a sealing ring is installed in the groove. The first step abuts against the sealing ring. Accordingly, after the base body 151 is mounted in the first mounting opening 1121, the first mounting opening 1121 is sealed, thereby ensuring that the sealed chamber remains in a sealed state.

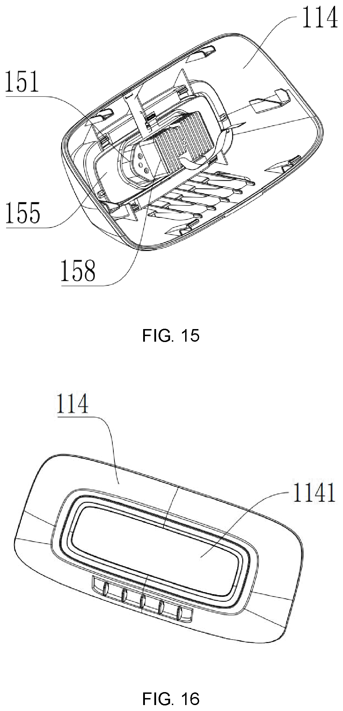

In some embodiments, as shown in FIG. 15 and FIG. 16, the second housing 11 further includes a front housing 114. A window opening 1141 corresponding to the lens 155 is provided at the front housing 114. The front housing 114 is fixed to the bottom housing 112 and the upper housing 111 and covers the front end portion 152 of the base body 151. The lens 155 abuts against an edge of the window opening 1141 in the front housing 114. After installation, the front housing 114, the bottom housing 112, and the upper housing 111 define a space region in which the camera module 15 is accommodated. The front housing 114 protects and shields the camera module 15.

In some embodiments, as shown in FIG. 4 and FIG. 11, the upper housing 111 is provided with a second mounting opening 1111 communicating with the sealed chamber. A button module 16 is disposed on the upper housing 111. The button module 16 includes a button housing 161, an elastic piece 167, a button switch 163, and a button circuit board 162.

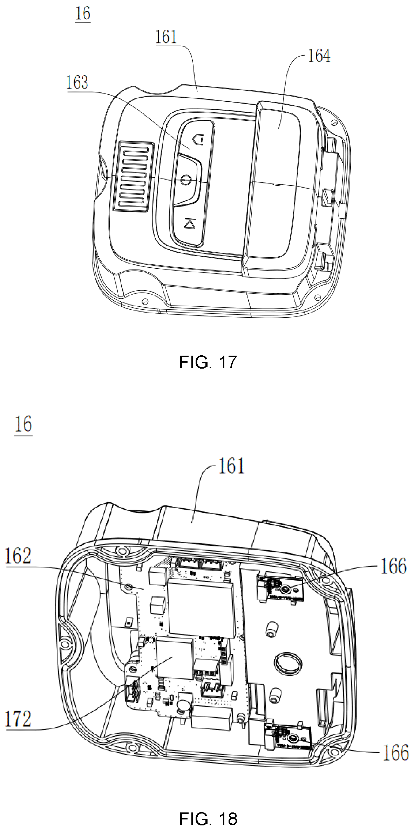

In an embodiment, as shown in FIG. 17 to FIG. 19, the button housing 161 is sealingly connected to the second mounting opening 1111. A first through hole 133 communicating with the sealed chamber is formed in the button housing 161. The button housing 161 includes a first side and a second side opposite to the first side, and the first side of the button housing 161 faces the sealed chamber. The elastic piece 167 is fixed to the first side of the button housing 161 and seals the first through hole 133. The button switch 163 is disposed on the elastic piece 167 and movably extends through the first through hole 133. The button circuit board 162 is fixed to the first side of the button housing 161 and is located on a side of the elastic piece 167 away from the button housing 161. A tactile switch corresponding to the button switch 163 is disposed on the button circuit board 162. The button circuit board 162 is electrically connected to the control module 12.

The button housing 161 may be fixed to the second mounting opening 1111 through a threaded connection. A cavity is formed on a side of the button housing 161 connected to the upper housing 111. The button housing 161 and the upper housing 111 jointly define an inner cavity communicating with the sealed chamber. The inner cavity communicates with the sealed chamber but is isolated from the outside of the housing, thereby preventing rainwater from entering the inner cavity. The button circuit board 162 is disposed within the inner cavity and is electrically connected to the control module 12. The button switch 163 is pressed and connected to the button housing 161. When the button switch 163 is pressed, the button switch 163 moves within the first through hole 133 based on deformation of the elastic piece 167. During movement, the button switch 163 actuates the tactile switch into contact with the button circuit board 162. After the tactile switch is actuated, the control module 12 controls the actuator to perform the operations described above.

In a recessed cavity of the button housing 161, a ring of supporting ribs is provided at a side of the button housing 161 close to the upper housing 111. A plurality of fixing posts are provided around the supporting ribs. A button circuit board 162 is fixed on the fixing posts. An annular supporting member is placed on the button circuit board 162, and the fixing posts limit the supporting member on an inner side. An elastic piece 167 is supported on the supporting member, and the elastic piece 167 is pressed by the supporting ribs, that is, the elastic piece 167 is clamped and pressed by the supporting member and the supporting ribs, thereby blocking the first through hole 133 from the recessed cavity.

The elastic piece 167 includes a main body and a pressing portion, and the pressing portion is connected to a button switch 163. A tactile switch is provided at the button circuit board 162 at a position corresponding to the pressing portion. Taking starting the mowing robot 10 as an example, when the button switch 163 is pressed, the main body deforms, causing the pressing portion to move downward and trigger the tactile switch, so that the mowing robot 10 is turned on.

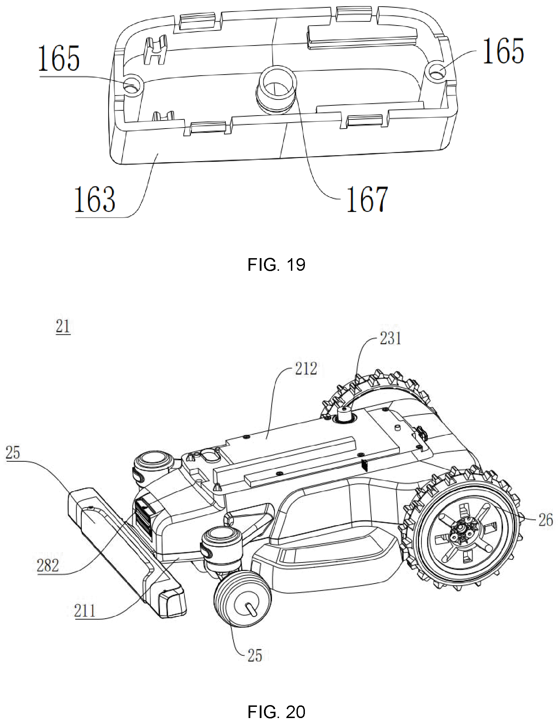

In some embodiments, as shown in FIG. 18 and FIG. 19, the button module 16 further includes an emergency stop button 164 pressed and connected to the button housing 161. A third detection portion 165 is provided at a bottom of the emergency stop button 164. A third trigger portion 166 electrically connected to the control module 12 is provided at the button housing 161. When the emergency stop button 164 is pressed, the third detection portion 165 is driven to move. During the movement, the third detection portion 165 approaches and triggers the third trigger portion 166, so that the control module 12 controls the actuator to perform an emergency braking.

In an embodiment, the button housing 161 is recessed on a side away from the upper housing 111 to form a groove. The emergency stop button 164 is disposed in the groove. A balance rod and a return spring are provided at a bottom of the emergency stop button 164. The emergency stop button 164 is in a limiting fit with a groove wall of the groove, and is installed in the groove in a liftable manner. The balance rod and the return spring are located in the groove and between a bottom wall of the groove and the emergency stop button 164.

The balance rod includes a pair of balance rods arranged crosswise. One end of each balance rod is rotatably provided with the groove wall of the groove or the emergency stop button 164, and the other end is slidably provided with the emergency stop button 164 or the groove wall of the groove, so as to ensure that no matter where the emergency stop button 164 is pressed, the emergency stop button 164 can be raised and lowered smoothly. The two balance rods are rotatably connected at a middle portion thereof, and are provided with an avoidance hole for avoiding the return spring. A top of the return spring is connected to the emergency stop button 164, and a bottom of the return spring is connected to a groove bottom of the groove. The return spring is used to support the lifting of the emergency stop button 164. The third detection portion 165 is mounted on the emergency stop button 164, and the third trigger portion 166 is mounted on an inner side of the button housing 161 at a position corresponding to the third detection portion 165.

When the emergency stop button 164 is pressed downward, the third detection portion 165 triggers the third trigger portion 166. The third trigger portion 166 is electrically connected to the control module 12, and the control module 12 controls the travelling motor 261 and/or the cutting motor 221 to brake, that is, to stop working.

In some embodiments, as shown in FIG. 6 to FIG. 8, a first positioning module 17 is provided at the upper housing 111. The first positioning module 17 includes a positioning antenna 171 and a positioning chip 172; the positioning antenna 171 is used for receiving a positioning signal, and may be an RTK antenna; the positioning chip 172 is used for processing the positioning signal, and may be a GPS chip. The positioning antenna 171 is fixed on the upper housing 111 and is located in the sealed chamber. The positioning chip 172 is disposed on the button circuit board 162 and is electrically connected to the positioning antenna 171 and the control module 12. By disposing the positioning chip 172 on the button circuit board 162, the positioning chip 172 can be assembled and disassembled by only removing the button housing 161, without removing the upper housing 111 and other components, facilitating subsequent maintenance of the positioning chip 172. Certainly, in other embodiments, the positioning chip 172 may also be disposed on a base board.

In some embodiments, as shown in FIG. 2 to FIG. 12, a handle 18 is further provided at the housing. An operator can conveniently carry the robot through the handle 18. The handle 18 is staggered in position with respect to the air outlet 136, so as to reduce hot air from the channel structure 131 from blowing onto the handle 18, to avoid burns when holding the handle 18, and to slow down aging of the handle 18.

In an embodiment, the handle 18 includes a handle portion a and a handle portion b. The handle portion a and the handle portion b are fixed together by screws to form the complete handle 18. The handle portion a is integrally formed with the bottom housing 112 to ensure the strength of the handle 18.

In some embodiments, the bottom housing 112 is provided with a rear housing 1122 covering the air outlet 136. The rear housing 1122 is provided with an air guiding window 1123 corresponding to the air outlet 136. The air guiding window 1123 may be in the form of a louver. An air outlet direction of the air guiding window 1123 is staggered from the handle 18, and the air guiding window 1123 can guide the air from the air outlet 136 toward the ground, further reducing hot air from blowing onto the handle 18.

In some embodiments, as shown in FIG. 20 to FIG. 25, the first housing 21 includes a cover body 212 located at a top of the first housing 21. The second housing 11 is detachably connected to the cover body 212. The first housing 21 further includes a chassis 211 connected below the cover body 212. The actuator is disposed on the chassis 211, and the cover body 212 covers at least a portion of the actuator.

The cover body 212 is snap-fitted onto the chassis 211 and together with the chassis 211 defines a mounting cavity. The second housing 11 is connected to the cover body 212 through the bottom housing 112. The mounting cavity is used to accommodate and cover a portion of the actuator. A connection between the cover body 212 and the chassis 211 is detachable, for example, by screwing. Similarly, a connection between the bottom housing 112 of the second housing 11 and the cover body 212 is also detachable by screwing.

In an embodiment, for convenience of describing an orientation of the chassis 211, in the following embodiments, the chassis 211 has two opposite sides: a side facing the ground is a lower side, and a side facing the sky is an upper side. Along a traveling direction of the mowing robot 10, the chassis 211 has a rear end and a front end opposite to the rear end.

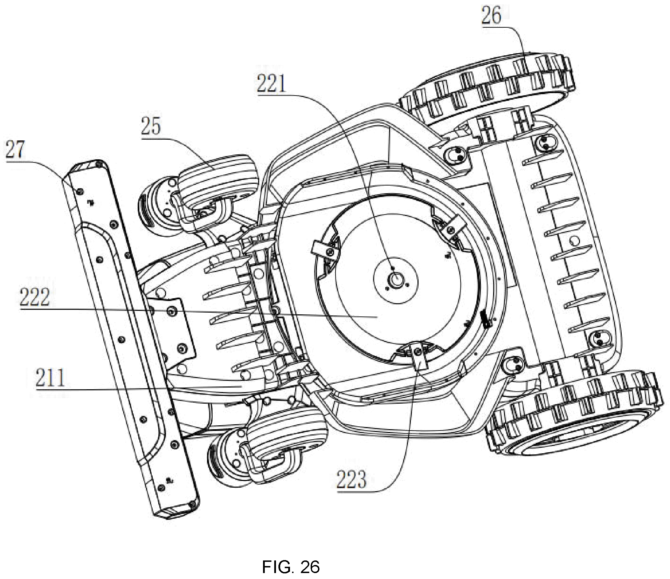

In some embodiments, as shown in FIG. 26 to FIG. 27, the actuator includes a cutting mechanism 22, and the chassis 211 is provided with a mounting groove 225 having an outward-facing slot opening. The cutting mechanism 22 is mounted within the mounting groove 225.

The cutting mechanism includes a connecting seat 226, a first mounting seat 227, a cutting motor 221, and a cutting structure. At least a portion of the connecting seat 226 is provided within the mounting groove 225 and is connected to the chassis 211. The first mounting seat 227 is connected to the connecting seat 226. The first mounting seat 227 is provided with a first mounting chamber and a second through hole communicating the first mounting chamber with the outside. The cutting motor 221 is disposed within the first mounting chamber, and an output shaft of the cutting motor 221 extends out of the first mounting chamber through the second through hole. The cutting structure is located outside the first mounting chamber and connected to the output shaft of the cutting motor 221.

In an embodiment, at least a portion of the connecting seat 226 is provided within the mounting groove 225 and detachably fixed to the chassis 211. The first mounting seat 227 is connected to the connecting seat 226. The first mounting seat 227 is provided with the first mounting chamber and the second through hole communicating the first mounting chamber with the outside. The cutting motor 221 is disposed within the first mounting chamber, thereby protecting the cutting motor 221. The output shaft of the cutting motor 221 extends out of the first mounting chamber through the second through hole, and the cutting structure is located outside the first mounting chamber and is connected to the output shaft of the cutting motor 221.

The first mounting chamber can protect the cutting motor 221. During movement and mowing operations of the mowing robot, obstacles such as stones and stumps having heights lower than the chassis 211 may inevitably be encountered. When the mowing robot passes over such obstacles, the chassis 211 crosses above the obstacles, while the cutting motor 221 is located on the side of the chassis 211 facing the ground, and is thus prone to being scratched or hit by obstacles such as stones, wooden stakes, and the like, causing damage. After the cutting motor 221 is accommodated in the first mounting chamber, these obstacles can be blocked from scratching or hitting the cutting motor 221 to a certain extent, thereby reducing the risk of damage to the cutting motor 221 due to such collisions.

In an embodiment, the connecting seat 226 is detachably fixed inside the mounting groove 225 by bolts. Both the connecting seat 226 and the mounting groove 225 are provided with threaded holes and are fastened together by bolts.

In an embodiment, the first mounting seat 227 may be fixed to the connecting seat 226. For example, the first mounting seat 227 may be integrally molded with the connecting seat 226 by an injection molding process. Alternatively, the first mounting seat 227 may be detachably connected to the connecting seat 226 by bolts, which is not limited in the present application.

In some embodiments, in order to reduce grass clippings, debris, and other foreign matter generated during mowing from entering the first mounting chamber of the first mounting seat 227, a chamber cover 212 is provided at the first mounting chamber. The chamber cover 212 covers the opening of the first mounting chamber, allowing the cutting motor 221 to operate in a clean environment, thereby improving the service life of the cutting motor 221.

To further reduce debris from entering the first mounting chamber through the surrounding sidewalls of the first mounting seat 227 and through the second through hole, portions of the first mounting seat 227 other than the chamber opening and the second through hole are configured as solid structures (namely, not hollow structures). The diameter of the output shaft of the cutting motor 221 is matched to, or slightly smaller than, the diameter of the second through hole. After assembly of the cutting mechanism 22, the output shaft of the cutting motor 221 can rotate within the second through hole while blocking the second through hole. As a result, debris cannot enter the first mounting chamber through the blocked second through hole or through the surrounding sidewalls of the first mounting seat 227. Accordingly, the cutting motor 221 can operate within a clean first mounting chamber, thereby reducing the risk of aging and damage and extending the service life of the cutting motor 221.

The cutting mechanism includes a blade disc 222. The blade disc 222 is fixed to the output shaft of the cutting motor 221. A plurality of blades 223 are rotatably mounted on the blade disc 222. Upon activation of the cutting motor 221, the output shaft of the cutting motor 221 is driven to rotate, and the output shaft drives the blade disc 222 to rotate. The rotating blades 223 mounted on the blade disc 222 cut weeds and grass, thereby performing mowing operations.

In an embodiment, the blades 223 are rotatably mounted on the blade disc 222. When the blade disc 222 rotates, the blades 223 are driven by centrifugal force to rotate into a horizontal or substantially horizontal position to perform mowing.

The blade disc 222 is fixed to the output shaft of the cutting motor 221 through a flange connection.

During mowing operations, the rotating blade disc 222 and blades 223 may cause cut grass to be scattered outwardly, making it easy for grass clippings to enter the first mounting seat 227, particularly when no chamber cover is provided. To reduce such occurrences, the cutting mechanism 22 further includes a protective cover. The protective cover is fixed to the first mounting seat 227, located outside the first mounting chamber, and provided above the cutting mechanism 22.

Accordingly, during mowing operations, grass clippings scattered outwardly are blocked by the protective cover, thereby preventing the grass clippings from entering the first mounting chamber of the first mounting seat 227, reducing the scattering range of the clippings, and improving user experience.

Electrical wires of the cutting motor 221 extend through a wire passing hole in the chamber cover 212, pass through a wire passing hole for the cutting motor 221 in the chassis 211 and a high-voltage wire through hole 2121 in the cover body, and are finally connected to the control module 12.

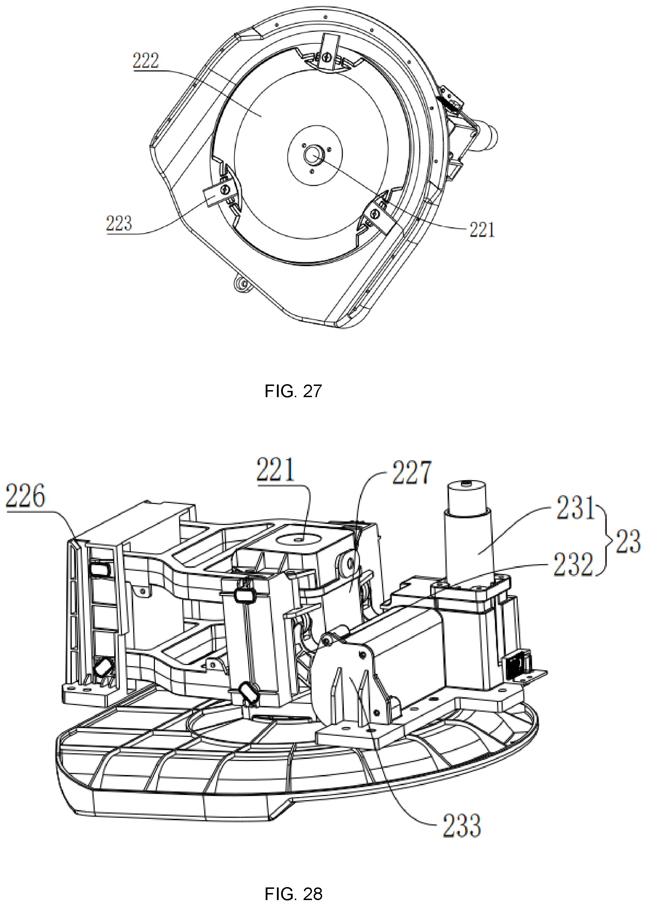

In some embodiments, as shown in FIG. 28 to FIG. 29, the cutting mechanism 22 further includes a height adjustment device 23. The first mounting seat is movably connected to the connecting seat, and the height adjustment device 23 is detachably mounted within the mounting groove. The first mounting seat is provided on the height adjustment device 23, and the height adjustment device 23 is configured to drive the first mounting seat to move upward and downward.

The height adjustment device 23 includes a second mounting seat 233, a height adjustment motor 231, a transmission assembly 232, and a swing arm 234. At least a portion of the second mounting seat 233 is provided within the mounting groove and detachably fixed to the chassis. The height adjustment motor 231 is disposed on the second mounting seat 233. The transmission assembly 232 is disposed on the second mounting seat 233 and connected to the height adjustment motor 231. The height adjustment motor 231 is configured to drive movement of the transmission assembly 232. The swing arm 234 is rotatably mounted on the second mounting seat 233 and connected to the transmission assembly 232. The transmission assembly 232 is configured to drive rotation of the swing arm 234, and the first mounting seat is provided on the swing arm 234.

After the height adjustment motor 231 drives the transmission assembly 232, the transmission assembly 232 drives the swing arm 234 to rotate. One end of the swing arm 234 is rotatably connected to the second mounting seat 233. Therefore, when the swing arm 234 rotates, the other end of the swing arm 234 will swing relative to the second mounting seat 233, thereby driving the first mounting seat to move up and down. In other words, the first mounting seat reciprocates in a direction away from the mounting groove and toward the mounting groove. The cutting mechanism moves up and down together with the first mounting seat, thereby adjusting the cutting height of the cutting mechanism.

In an embodiment, the second mounting seat 233 is detachably connected to the chassis by bolts. Alternatively, the second mounting seat 233 may be connected to the chassis by a snap-fit structure, which is not limited in the present application.

In some embodiments, the transmission assembly 232 includes a screw rod 235 and a gear 236. The screw rod 235 is connected to the height adjustment motor 231, and the gear 236 is connected to the swing arm 234. The screw rod 235 is in meshing engagement with the gear 236. The height adjustment motor 231 drives the screw rod 235 to rotate, and the screw rod 235 drives the gear 236 to rotate through meshing engagement. The rotating gear 236 drives the swing arm 234 to swing, thereby achieving height adjustment of the second mounting seat 233.

Of course, the transmission mode of the transmission assembly 232 is not limited to the above-described gear transmission mode. Other transmission modes, such as hinge transmission or belt transmission, may also be employed, as long as the rotation of the height adjustment motor 231 can be transmitted to the swing arm 234 to cause the swing arm 234 to swing, which is not limited in the present application.

The cutting module further includes a height detection mechanism 24. The height detection mechanism 24 includes a first detection module. The first detection module includes a first detection portion 241 and a first trigger portion 242. One of the first detection portion 241 and the first trigger portion 242 is connected to the gear 236 along with the movement, and the other one of the first detection portion 241 and the first trigger portion 242 is fixed on the second mounting seat 233.

In an embodiment, the first trigger portion 242 is fixed on the gear 236. Two first detection portions 241 are installed on the sidewall of the second mounting seat 233 from top to bottom. When the first trigger portion 242 approaches one first detection portion 241, the first detection portion 241 is triggered and outputs a first detection signal. The first detection portion 241 is electrically connected to a controller of the mowing robot, so as to transmit the first detection signal the controller. The controller performs functional limitation on various functional modules of the mowing robot according to the first detection signal. For example, the first detection portion 241 may be a Hall sensor, and the first trigger portion 242 may be a magnet. When the magnet approaches the Hall sensor, the magnetic field strength around the Hall sensor changes, thereby triggering the Hall sensor.

It can be understood that during the lifting movement, the first mounting seat cannot be too high or too low. If the first mounting seat rises too high, the first mounting seat will abut against the chassis and cannot continue to rise, which may easily damage the lifting motor. Moreover, if the first mounting seat descends too low, the blade disc will touch the ground and become damaged. Therefore, the swing arm 234 has a certain lifting range requirement during the swinging movement, which is defined herein as a first height and a second height, respectively, with the second height being higher than the first height.

Since the gear 236 drives the swing arm 234 to move up and down through rotation, the gear 236 also rotates to a first position and a second position during operation. When the gear 236 rotates to the first position, the swing arm 234 moves to the first height. When the gear 236 rotates to the second position, the swing arm 234 moves to the second height.

Accordingly, the two first detection portions 241 are respectively provided at the uppermost position and the lowermost position corresponding to the allowable swing range of the swing arm 234, that is, at positions on the second mounting seat 233 corresponding to the first position and the second position. During vertical movement of the swing arm 234, when the swing arm 234 reaches the second height or descends to the first height, the first trigger portion 242 on the gear 236 triggers the corresponding first detection portion 241. The first detection portion 241 then sends a first detection signal to the controller. Upon receiving the first detection signal, the controller can control the height adjustment motor 231 to brake, thereby preventing the second mounting seat 233 and the cutting mechanism from being excessively high or excessively low and improving operational safety.

In an embodiment, the height detection mechanism 24 further includes a second detection module configured to calculate the lifting height of the cutting module. The second detection module includes a second detection portion and a second trigger portion. One of the second detection portion and the second trigger portion is disposed on the screw rod 235, and the other one of the second detection portion and the second trigger portion is disposed on a sidewall of the second mounting seat 233. For example, the second detection portion may be a Hall sensor and the second trigger portion may be a magnet. Similar to the above embodiment, when the second detection portion and the second trigger portion approach each other, the second detection portion is triggered and sends a second detection signal to the controller.

It can be understood that the lifting height of the first mounting seat can be calculated according to the number of rotations of the screw rod 235 in combination with the transmission ratio. Each time the screw rod 235 completes one revolution, the second trigger portion may trigger the second detection portion once. According to the number of times the second detection portion is triggered, namely the number of second detection signals received by the controller, the number of revolutions of the screw rod 235 can be determined, thereby calculating the lifting height of the first mounting seat. For example, when the screw rod 235 rotates one turn, the swing arm 234 rises or falls by a height a. Then, according to the number of times the controller receives the second detection signal, the number of turns b of the screw rod 235 can be determined, and thus the lifting height h of the swing arm 234 can be determined, where h = a * b. In this way, measurement of the lifting height of the first mounting seat can be achieved.

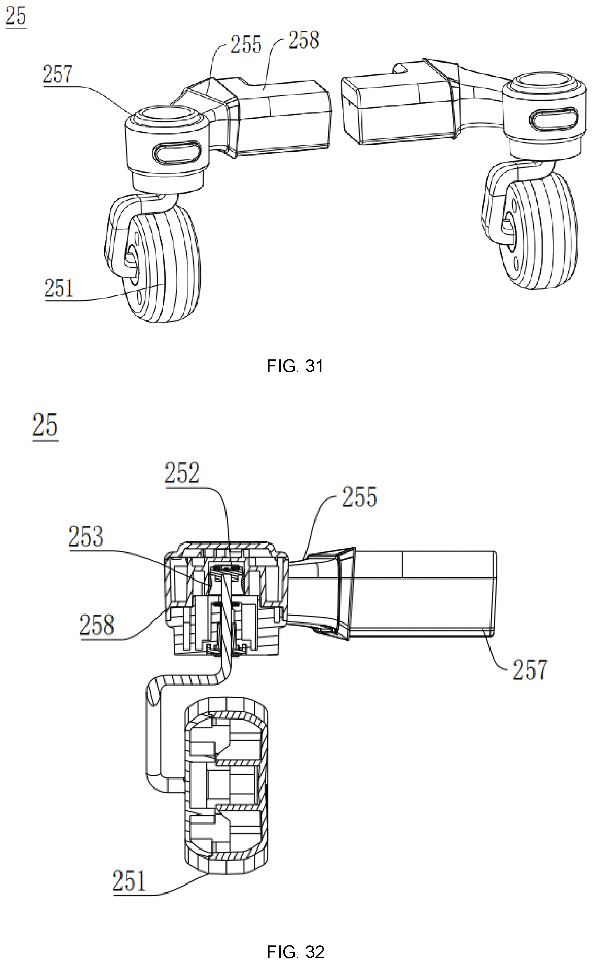

In some embodiments, the actuator includes a travelling mechanism, and the travelling mechanism includes a driven wheel module 25 and a driving wheel module 26. As shown in FIG. 31 to FIG. 35, the driving wheel module 26 includes a travelling motor 261 and a first wheel body 262 coupled to the travelling motor 261. The travelling motor 261 is fixed on the chassis 211 and electrically connected to the control module 12. The control module 12 is configured to drive the travelling motor 261, so that the first wheel body 262 rotates and drives the mowing robot 10 to move. The direction from the driven wheel module 25 toward the driving wheel module 26 is defined as the travelling direction of the mowing robot 10.

In an embodiment, the chassis 211 is provided with a first mounting compartment 263. The driving wheel module 26 includes the travelling motor 261 and the first wheel body 262 driven to rotate by the travelling motor 261. The chassis 211 is further provided with a third through hole 264 communicating the first mounting compartment 263 with the outside. The travelling motor 261 extends into the first mounting compartment 263 through the third through hole 264. A first connecting lug 265 is provided at the outer periphery of the travelling motor 261. A first connecting portion 266 surrounding the first through hole is provided at the outer side of the chassis 211. After the travelling motor 261 extends into the first mounting compartment 263 through the first through hole, the first connecting portion 266 abuts against the first connecting lug 265. The first connecting portion 266 is fixed to the first connecting lug 265 by a first fastening element in a threaded connection. The first wheel body 262 is located outside the first mounting compartment 263.

When installing the driving wheel module 26, the travelling motor 261 is extended from the outside of the first mounting compartment 263 into the interior of the first mounting compartment 263 through the third through hole 264. After the travelling motor 261 extends into the first mounting compartment 263, the travelling motor 261 is fixed to the outer side of the chassis, thereby accommodating at least a portion of the travelling motor 261 in the first mounting compartment 263. After the driving wheel module 26 is mounted on the chassis 211, the first wheel body 262 is located outside the first mounting compartment 263 and is configured to roll on the ground.

When disassembling the driving wheel module 26, the connection between the travelling motor 261 and the chassis is first released, and the travelling motor 261 is then withdrawn from the first mounting compartment 263, thereby completing the disassembly process.

The travelling motor 261 provided in the embodiments of the present application is operated with respect to the first mounting compartment 263 on the chassis during both assembly and disassembly. Since the first mounting compartment 263 directly communicates with the outside through the third through hole 264 and does not involve other structures of the housing, no other housing components need to be removed during installation or disassembly. The travelling motor 261 can be directly installed into or removed from the first mounting compartment 263 of the chassis 211 from the outside, enabling modular external disassembly, simplifying the assembly and disassembly steps of the driving wheel module 26, making the assembly and disassembly of the driving wheel module 26 more convenient, and improving the assembly and disassembly efficiency of the driving wheel module 26.

In some embodiments, after the travelling motor 261 extends into the first mounting compartment 263, the travelling motor 261 is detachably fixed to the outer side of the chassis 211 through the first connecting lug 265. The outer periphery of the travelling motor 261 is provided with the first connecting lug 265, and the outer side of the chassis 211 is provided with a first connecting portion 266 surrounding the third through hole 264. The first connecting portion 266 is configured to abut against the first connecting lug 265 after the travelling motor 261 extends into the first mounting compartment 263 through the third through hole 264. The first connecting portion 266 is fixed to the first connecting lug 265 through a threaded connection by means of a first fastening element.

During installation, the travelling motor 261 is inserted into the first mounting compartment 263 through the third through hole 264. The first connecting lug 265 moves together with the travelling motor 261 and cannot pass through the third through hole 264. The first connecting lug 265 abuts with the first connecting portion 266 surrounding the third through hole 264. In this case, the travelling motor 261 no loner extends into the first mounting compartment 263. The first connecting lug 265 is then screwed to the first connecting portion 266 by the first fastening element, thereby positioning and fixing the travelling motor 261 on the chassis 211.

During removal of the travelling motor 261, the first fastening element is removed, so that the connection between the first connecting lug 265 and the first connecting portion 266 is released. The travelling motor 261 can then be withdrawn from the first mounting compartment 263, thereby completing removal of the driving wheel module 26.

When installing the driving wheel module 26, the first connecting lug 265 abuts against the outer side of the chassis 211. Accordingly, the first connecting lug 265 serves not only as a fastening structure but also as a positioning structure. An operator does not need to determine the insertion depth of the travelling motor 261 into the first mounting compartment 263 during installation. Once the first connecting lug 265 abuts against the first connecting portion 266, the operator can determine that the travelling motor 261 has reached the predetermined installation position. This reduces installation difficulty while enabling accurate positioning.

The first wheel body 262 includes a decorative wheel cover and a rear cover located on opposite sides of the first wheel body 262. The first wheel body 262 is clamped between the decorative wheel cover and the rear cover. The decorative wheel cover and the rear cover mainly serve to cover internal components of the first wheel body 262 for decorative purposes and to prevent collision debris and other foreign matter from entering the interior of the first wheel body 262. The first wheel body 262 includes a wheel hub and a tire body sleeved around the outer periphery of the wheel hub. The tire body is provided with a plurality of tread teeth to improve the ground gripping performance of the first wheel body 262.

The driven wheel module 25 is mounted on the chassis 211. The chassis 211 and the cover body 212 are enclosed to form a second mounting compartment 254. The driven wheel module 25 includes a mounting arm 255 and a second wheel body 251. Opposite ends of the mounting arm 255 in a length direction are respectively defined as a first end 257 and a second end 258. The cover body is provided with a fourth through hole 256 communicating the second mounting compartment 254 with the outside. The first end 257 extends into the second mounting compartment 254 through the fourth through hole 256 and is detachably connected to the chassis, while the second end 258 is located outside the second mounting compartment 254 and connected to the second wheel body 251.

When the driven wheel module 25 is mounted on the chassis 211, the first end 257 of the mounting arm 255 is inserted into the second mounting compartment 254 and connected to the chassis 211. Assembly and disassembly of the driven wheel module 25 are both performed with respect to the second mounting compartment 254 on the chassis 211. Since the second mounting compartment 254 directly communicates with the outside through the fourth through hole 256 and does not involve other structures of the chassis 211, no additional structures of the chassis 211 or the first housing 21 need to be removed during assembly or disassembly. The mounting arm 255 of the driven wheel module 25 can be directly installed into or removed from the second mounting compartment 254 from outside, thereby achieving modular external assembly and disassembly. This simplifies the assembly and disassembly procedures of the driven wheel module 25, makes maintenance more convenient, and improves assembly and disassembly efficiency.

Moreover, the second end 258 of the mounting arm 255 can extend to a lateral side of the chassis 211. Since the mounting arm 255 has a certain length, a portion of the driven wheel module 25 can extend laterally beyond the chassis 211. As a result, the spacing between the second wheel bodies 251 is no longer limited by the width of the chassis 211. Increasing the spacing between the second wheel bodies 251 improves travelling stability of the mowing robot and reduces the likelihood of rollover when travelling uphill or downhill.

In some embodiments, the mounting arm 255 is detachably connected to the chassis 211 by a threaded connection. In an embodiment, the first end 257 is provided with a threaded hole 313, and the chassis 211 is provided with a first mounting hole 114 corresponding to the threaded hole 313. The chassis 211 is fixed to the mounting arm 255 by a second fastening element extending through the first mounting hole 114 and engaging the threaded hole 313.

During installation of the driven wheel module 25, the first end 257 of the mounting arm 255 is inserted into the second mounting compartment 254 through the fourth through hole 256. Then, from the outside of the chassis 211, a second fastening element is inserted into the first mounting hole 114 and the threaded hole 313 of the first end 257, thereby fixing the first end 257 of the mounting arm 255 to the chassis 211. During removal of the driven wheel module 25, the second fastening element is removed from the outside of the chassis 211. Then the mounting arm 255 can be withdrawn from the second mounting compartment 254, thereby completing removal of the driven wheel module 25.

Furthermore, the first end 257 of the mounting arm 255, which serves as the fixing portion, is concealed within the second mounting compartment 254 rather than being exposed outside the chassis 211, thereby providing a cleaner and more aesthetically pleasing appearance for the mowing robot.

In some embodiments, the second wheel body 251 includes an axle seat, a wheel axle, and a caster wheel. The axle seat is detachably connected to the mounting arm 255. An axle hole extends through the axle seat. One end of the wheel axle is rotatably mounted within the axle hole, and the caster wheel is rotatably mounted on the other end of the wheel axle.

During assembly of the driven wheel module 25, the axle seat is connected to the second end 258 of the mounting arm 255, and the caster wheel is rotatably connected to the axle seat through the wheel axle.

Since the axle seat is detachably connected to the second end 258 of the mounting arm 255, when only the second wheel body 251 requires maintenance, the second wheel body 251 can be removed from the mounting arm 255 for repair or replacement without replacing the entire driven wheel module 25, thereby saving time, labor, and cost.

In some embodiments, as shown in FIG. 32, the driven wheel module 25 further includes a conductive block 252 and an elastic electrode piece 253 disposed on the second wheel body 251. When the second wheel body 251 is lifted from the ground or suspended, the conductive block 252 contacts with and electrically connects to the elastic electrode piece 253, so that the control module 12 can control the travelling mechanism and the cutting mechanism 22 to brake.

In an embodiment, a mounting cavity is provided in a lower portion of a connecting arm, and a portion of the wheel axle seat extends into the mounting cavity. An axle hole extends through the wheel axle seat. One end of the wheel axle passing through the axle hole can move up and down and rotate within the axle hole. Protruding ribs are provided at opposite sides of the axle hole, and the elastic electrode piece 253 is fixed to the protruding ribs. The elastic electrode piece 253 is electrically connected to a connection terminal disposed within the mounting cavity, and the connection terminal is connected to the control module 12. The conductive block 252 is fixed to an end portion of the wheel axle.

When the wheel axle moves upward, the conductive block 252 is separated from the elastic electrode piece 253. When the wheel axle moves downward, the conductive block 252 contacts the elastic electrode piece 253, thereby electrically connecting the electrode pieces. The control module 12 receives an electrical signal indicating that the mowing robot has been lifted or that the wheel is suspended. The control module 12 then controls the travelling motor 261 to drive the rear wheel to stop operating and also controls the cutting motor 221 to stop operating.

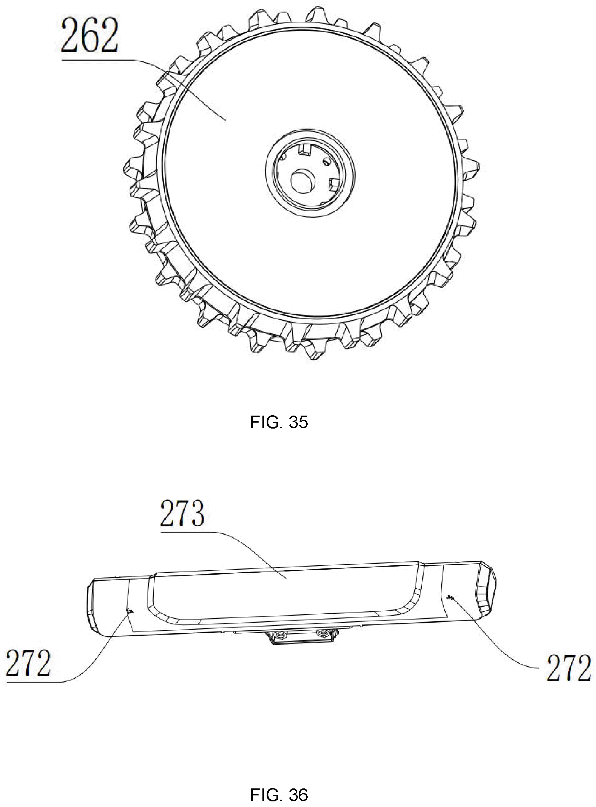

In some embodiments, the chassis 211 is provided with a collision module 27. As shown in FIG. 36 to FIG. 39, the collision module 27 includes a support portion 271 and a movable cover body 273. The support portion 271 is fixed to the chassis and is provided with a detection element 272 electrically connected to the control module. The movable cover body 273 is provided with a receiving chamber 274. The support portion 271 is disposed within the receiving chamber 274, and a movable gap is maintained between the support portion 271 and the movable cover body 273. An elastic member 275 elastically supports between the inner wall of the receiving chamber 274 and the support portion 271. The elastic member 275 allows the movable cover body 273 to move relative to the support portion 271 upon collision and to return to the original position after the collision ceases. A trigger element 276 is provided at the inner wall of the receiving chamber 274.

The trigger element 276 is configured to trigger the detection element 272 when approaching the detection element 272. After being triggered, the detection element 272 sends a collision signal to the control module 12. The control module 12 is configured to receive the collision signal and control the travelling mechanism to brake in response thereto.

The detection element 272 and the trigger element 276 form a set of cooperating detection components. During operation, displacement of the movable cover body 273 relative to the support portion 271 results in relative displacement between the detection element 272 and the trigger element 276. The trigger element 276 then triggers the detection element 272, then the detection element 272 generates an electrical signal and transmits the signal to the control module 12 of the mowing robot. Based on the electrical signal, the mowing robot can determine that the movable cover body 273 has encountered an obstacle or experienced an impact, and can accordingly modify the travelling strategy to avoid the obstacle.

In some embodiments, the movable cover body 273 is supported around the outer periphery of the support portion 271 by the elastic member 275.

It should be understood that the outer periphery of the support portion 271 refers to the region surrounding the outer side of the support portion 271. In other words, the outer side of the support portion 271 is enclosed by the movable cover body 273. Accordingly, when an external object approaches and impacts the support portion 271, the external object first contacts the movable cover body 273, causing displacement of the movable cover body 273 and triggering the detection element 272. This reduces the occurrence of situations in which a collision has occurred but is not detected, thereby lowering the missed-detection rate of collision detection. Furthermore, since the movable cover body 273 surrounds the outer periphery of the support portion 271, the support portion 271, the detection element 272, and the trigger element 276 are all provided within the movable cover body 273. The movable cover body 273 can protect these components, reducing the risk that the support portion 271, the detection element 272, the trigger element 276, and other components may be exposed to rainwater or become damaged.

In some embodiments, the cover body 212 is provided with a high-voltage wire through hole 2121 and a low-voltage wire through hole 2122 that are separately arranged and communicate with the sealed chamber. That is, the bottom housing 112 of the second housing 11 is provided with the high-voltage wire through hole 2121 and the low-voltage wire through hole 2122. High-voltage wires of the first housing 21 extend into the sealed chamber of the second housing 11 through the high-voltage wire through hole 2121 and are connected to the control module 12. Low-voltage wires of the first housing 21 extend into the sealed chamber of the second housing 11 through the low-voltage wire through hole 2122 and are connected to the control module 12. The high-voltage wire through hole 2121 and the low-voltage wire through hole 2122 are spaced apart from each other, and in some embodiments are provided diagonally opposite to each other, thereby further increasing the separation distance between the high-voltage wires and the low-voltage wires.

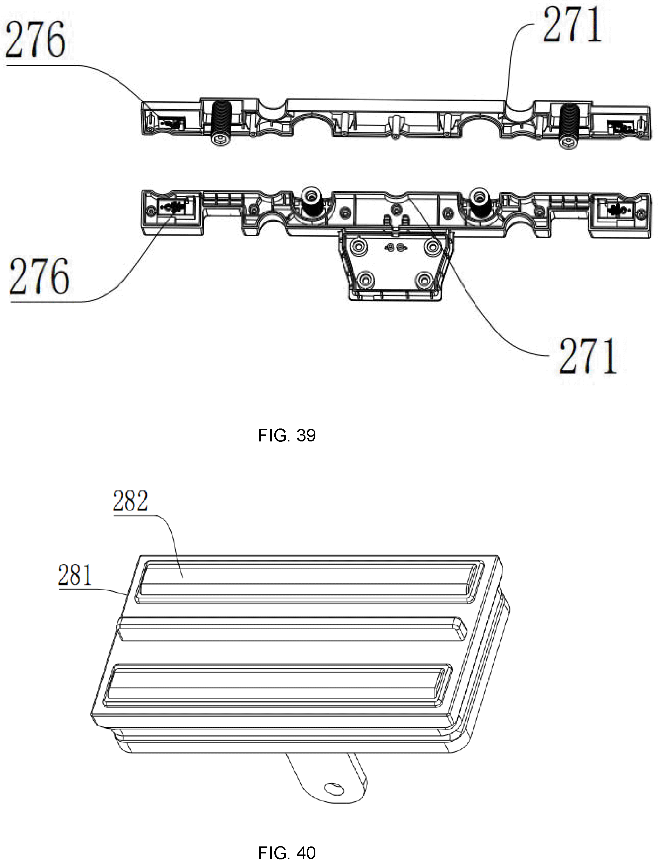

In some embodiments, the chassis 211 is provided with a battery compartment 28. A power supply for supplying power to the actuator and the control module 12 is disposed within the battery compartment 28. The power supply is connected to a charger plug 281 for charging. As shown in FIG. 40, the charger plug 281 is connected to the first housing 21 and provided with charging electrodes 282 exposed outside the first housing 21.

The chassis 211 is provided with the battery compartment 28, and a power supply for supplying power to the cutting structure, the travelling mechanism, and the collision module 27 is disposed inside the battery compartment 28. The power supply is connected to the charger plug 281 for charging. As shown in FIG. 40, the charger plug 281 is provided with charging electrodes 282 exposed outside the first housing 21, and the charging electrodes 282 are mounted on the charger plug 281.

In an embodiment, the charger plug 281 includes a charging base and charging electrodes 282 mounted on the charging base. The charging electrodes 282 respectively constitute a positive electrode and a negative electrode. The charging electrodes 282 are metal components, while the charging base is made of a flame-retardant material and may, for example, be a plastic component. A partition rib is provided at the charging base. The partition rib is higher than both the positive electrode and the negative electrode and is configured to prevent accidental electrical connection between the positive electrode and the negative electrode. The cover body 212 is provided with a charging port communicating with the sealed chamber, and the charger plug 281 is mounted in the charging port of the cover body 212. The charging base is further provided with a snap-fit structure, thereby enabling the charger plug 281 to be snap-fitted to the cover body 212. In addition, the charger plug 281 may also be screwed to the cover body 212 by threaded fasteners.

In an embodiment, the charging port is disposed at a front end of the cover body 212 and is configured to receive the charger plug 281. The charger plug 281 is capable of charging the power supply through the charging electrodes 282. The charging electrodes 282 of the charger plug 281 are exposed outside the cover body 212 to facilitate charging operations. A wire-routing groove is provided at an upper side of the chassis 211 for positioning wires connected to the charging electrodes 282. One end of the wire is connected to a charging electrode 282, and the other end of the wire passes through the high-voltage wire through hole 2121 and is connected to the control module 12. Wires connected to the power supply likewise pass through the high-voltage wire through hole 2121 and are connected to the control module 12.

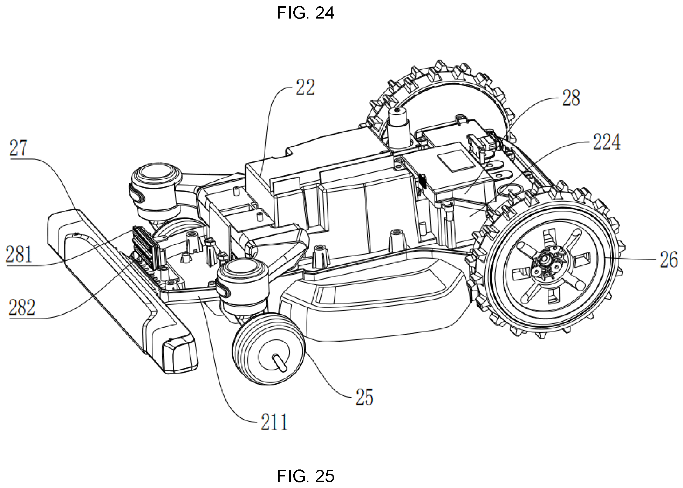

In some embodiments, as shown in FIG. 25, the battery compartment 28 is provided with a compartment cover. The compartment cover is provided with a vent valve, and a top wall of a mounting chamber for the travelling motor is also provided with a vent valve. The compartment cover provides a certain degree of waterproof protection while also maintaining air pressure balance within the battery compartment 28.

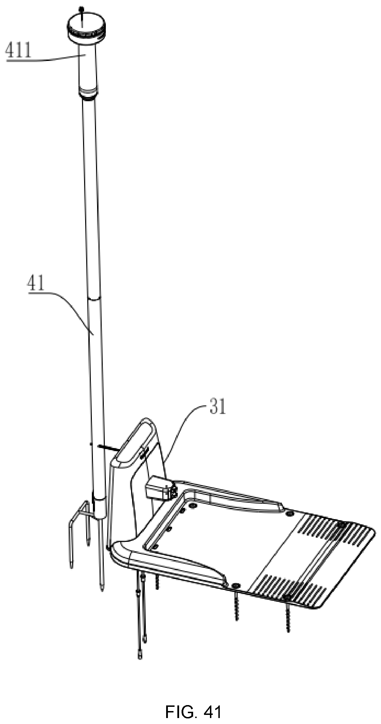

The present application further provides a mowing system. As shown in FIG. 41, the mowing system includes a charging pile 31, a base station 41, and the mowing robot 10 according to the foregoing embodiments. The charging pile 31 is provided with a charging mechanism configured to charge the mowing robot 10. The base station 41 is provided with a second positioning module 411, and the second positioning module 411 communicates with the first positioning module 17.

The charging pile and the base station are independent components that may be used separately or in combination. The charging pile is fixed on a lawn by ground nails, while the base station is secured in the soil of the lawn by insertion pins.

In an embodiment, the charging pile includes a base and a charging body vertically mounted on the base. The base is configured to support the mowing robot 10. A U-shaped guide protrusion is provided at an end of the base closed to the charging body. When the mowing robot 10 enters the base, the guide protrusion guides the mowing robot into alignment with the charging body. An anti-reverse protrusion is provided at an end of the base away from the charging body. When the mowing robot 10 is being charged, since the travelling motor 261 is in a stopped state in this case, especially when the grass is uneven, the anti-reverse protrusion can act as a blocking means to prevent the mowing robot 10 from moving away from the charging pile.

The charging body is vertically mounted on the base and includes a rear housing, a front housing, a middle housing, and a fixed housing assembled together. A charging chamber is provided within the charging body, and a charging circuit board is installed in the charging chamber. A mounting cover is integrally formed on the front housing. The mounting cover is provided with a mounting groove, and the charging body is mounted within the mounting groove. The charging body is electrically connected to the charging circuit board through wires. An electrode portion of the charging body extends out of the mounting groove through an opening at one end of the mounting groove and is exposed to the outside, so as to electrically contact the charger plug 281 on the mowing robot.

In an embodiment, the charging body includes a fixed housing and an electrode body. One end of the electrode body is fixed to the fixed housing, and the fixed housing is mounted in the mounting groove of the mounting cover. The fixed housing is further provided with an accommodating cavity in which wires connecting the electrode body and the charging circuit board are accommodated. A charging Hall sensor connected to the charging circuit board is further provided at the fixed housing, and a charging magnet is mounted on the electrode body. When the electrode body is pressed and displaced rearwardly, the charging magnet triggers the charging Hall sensor, and the charging circuit board controls the electrodes to begin charging the mowing robot.

The electrode body includes a spring electrode and a housing. The spring electrode includes a fixed end, a free end, and an elastic arm connecting the fixed end and the free end. The fixed end of the spring electrode is fixed to the fixed housing; the housing is disposed on the free end, and the elastic arm is bent to increase elasticity.

In conventional electrode structures, elasticity is generally provided by springs to increase tolerance and reduce the risk of damage during docking. In the present application, elasticity is provided by the spring electrode, thereby eliminating the need for a separate spring and resulting in a simpler structure and lower cost.

In an embodiment, the free-end portion of the spring electrode is enclosed within the housing. In an embodiment, a slot is provided in the housing, and the free end is mounted in the slot, with a contact area on the free end exposed outside the housing to contact the electrodes on the mowing robot. During the manufacturing process, the spring electrode and the housing are injection-molded together. That is, the spring electrode is first installed in a mold, then plastic is injected into the mold, and after cooling, the spring electrode fixed to the housing can be obtained.

Two electrode bodies are provided, respectively constituting a positive electrode and a negative electrode. The positive and negative electrodes are provided in a staggered and opposing manner, thereby balancing forces in the left-right direction.

In some embodiments, the charging pile body is provided with an identification structure mounted in a second mounting opening of the identification structure. The identification structure is configured to assist the mowing robot in docking with the charging pile.

The identification structure includes an outer cover and an identification board fixed to an inner side of the outer cover. When the identification structure is mounted on the charging body, the identification board is positioned between the outer cover and the charging body. As a result, the outer cover is directly visible from the outside, while the identification board is concealed inside.

In an embodiment, the identification board is a white reflective board configured to reflect infrared light. The identification board is made of acrylonitrile styrene acrylate resin and is in a square-ring shape. The identification board is fixed within the second mounting opening of the identification structure on the inner side of the outer cover. Since glossy surfaces may result in inconsistent light intensity received by a TOF camera and reduce feature-recognition accuracy, the reflective surface of the identification board is formed as a frosted surface. Through diffuse reflection, the reflected light becomes more uniform, thereby improving the recognition accuracy of the TOF camera.

The outer cover has a light-filtering function. In an embodiment, the outer cover is a black acrylic board produced by adding a functional colorant. The outer cover allows only infrared light to pass through. Since the outer cover generally exhibits weak reflective capability, the outer surface of the outer cover is configured as a frosted surface.

The above are only some embodiments of the present application, and do not limit the scope of the present application thereto. Any modifications, equivalent substitutions, improvements, and the like made within the spirit and principles of the present application shall fall within the claimed scope of the present application.

## Claims

1. A mowing robot, **characterized by** comprising:
a housing comprising a first housing and a second housing connected to the first housing, wherein the second housing and the first housing are vertically distributed;
an actuator provided at the first housing and configured to perform operations, the operations comprising driving the housing to move and performing cutting; and
a control module provided at the second housing and electrically connected to the actuator, the control module being configured to control the actuator to perform the operations.

2. The mowing robot according to claim 1, wherein the second housing is provided with a heat dissipation structure, and the heat dissipation structure is configured to dissipate heat from the control module.

3. The mowing robot according to claim 2, wherein the second housing comprises an upper housing and a bottom housing; the upper housing is fixed to the bottom housing and enclosed with the bottom housing to form a sealed chamber; and
the heat dissipation structure comprises a channel structure provided at the bottom housing; the channel structure is independent of the sealed chamber; the control module is provided within the sealed chamber and located outside the channel structure; the control module is abutted against a sidewall of the channel structure.

4. The mowing robot according to claim 3, wherein the heat dissipation structure further comprises a heat dissipation board provided at the bottom housing; the heat dissipation board forms a part of the sidewall of the channel structure; and the control module is abutted against the heat dissipation board.

5. The mowing robot according to claim 3, wherein a fan is provided within the channel structure; the fan is configured to regulate an air flow rate within the channel structure.

6. The mowing robot according to claim 3, wherein one end of the channel structure is an air inlet, and the other end of the channel structure is an air outlet; the air inlet is provided at one end of the bottom housing, and the air outlet is provided at the other end of the bottom housing; a filter screen is provided at each of the air inlet and the air outlet.

7. The mowing robot according to claim 4, wherein the control module comprises a base board and a core board; the base board is fixed to the bottom housing and provided above the heat dissipation board; the core board is provided at one side of the base board and located between the base board and the heat dissipation board; the core board is in contact with the heat dissipation board.

8. The mowing robot according to claim 7, wherein a heat transfer block is provided between the core board and the heat dissipation board; the heat transfer block is bonded to the core board through a first heat transfer adhesive layer; the first heat transfer block is bonded to the heat dissipation board through a second heat transfer adhesive layer.

9. The mowing robot according to claim 7, further comprising a communication module provided within the sealed chamber; wherein the communication module comprises:
a communication antenna supported on the bottom housing through a mounting post; and
a communication control board fixed to the base board and abutted against the heat dissipation board, wherein the communication control board is provided with a communication chip, and the communication chip is electrically connected to the communication antenna.

10. The mowing robot according to claim 3, wherein the second housing further comprises a decorative housing, the decorative housing covering the upper housing and being fixed to the bottom housing; the decorative housing, the upper housing and the bottom housing are enclosed to form a thermal insulation chamber surrounding the sealed chamber and positioned above the sealed chamber; the thermal insulation chamber is independent of the sealed chamber.

11. The mowing robot according to claim 3, wherein the bottom housing is provided with a first mounting opening communicating with the sealed chamber; the bottom housing is further provided with a camera module; the camera module comprises:
a base body provided with a front end portion, a rear end portion, and an accommodating chamber; wherein the accommodating chamber penetrates through the front end portion and the rear end portion; the base body is configured to extend into the sealed chamber through the first mounting opening; the front end portion is abutted against a surface of a side of the bottom housing away from the sealed chamber; the rear end portion is provided within the sealed chamber and connected to the bottom housing;
a lens mounted at the front end portion of the base body and configured to cover the accommodating chamber;
a camera group and an image pre-processing board electrically connected to the camera group; wherein at least a part of the camera group is mounted within the accommodating chamber; the image pre-processing board is configured to perform image pre-processing on images captured by the camera group; and
a heat sink mounted at the rear end portion of the base body and being abutted against the image pre-processing board; wherein at least a part of the heat sink is provided within the sealed chamber.

12. The mowing robot according to claim 11, wherein the second housing further comprises a front housing; the front housing is provided with a window opening corresponding to the lens; the front housing is fixed to the bottom housing and the upper housing; the lens is abutted against an edge of the window opening of the front housing.

13. The mowing robot according to claim 3, wherein the upper housing is provided with a second mounting opening communicating with the sealed chamber; the upper housing is provided with a button module; the button module comprises:
a button housing sealingly connected to the second mounting opening; a first through hole communicating with the sealed chamber is formed at the button housing; the button housing is provided with a first side and a second side opposite to the first side; the first side of the button housing is a side facing the sealed chamber;
an elastic piece fixed to the first side of the button housing and covering the first through hole;
a button switch provided at the elastic piece and movably passing through the first through hole; and
a button circuit board fixed to the first side of the button housing and located at a side of the elastic piece away from the button housing; the button circuit board is provided with a tactile switch corresponding to the button switch; the button circuit board is electrically connected to the control module.

14. The mowing robot according to claim 7, wherein the second housing is provided with a first positioning module, and the first positioning module comprises:
a positioning antenna fixed to the upper housing; wherein the positioning antenna is provided within the sealed chamber, and configured to receive a positioning signal; and
a positioning chip provided at the base board; wherein the positioning chip is electrically connected to the positioning antenna and configured to transmit and process the positioning signal.

15. The mowing robot according to any one of claims 1 to 14, wherein the first housing comprises a cover body provided at a top of the first housing, and the second housing is detachably connected to the cover body.

16. The mowing robot according to claim 15, wherein the first housing further comprises a chassis connected to a lower portion of the cover body; the actuator is provided at the chassis, and the cover body is configured to cover at least a part of the actuator.

17. The mowing robot according to claim 16, wherein the actuator comprises a cutting mechanism; the chassis is provided with a mounting groove having an outward-facing slot opening; the cutting mechanism is mounted inside the mounting groove; the cutting mechanism comprises:
a connecting seat, wherein at least a part of the connecting seat is provided inside the mounting groove and connected to the chassis;
a first mounting seat connected to the connecting seat, wherein the first mounting seat is provided with a first mounting chamber and a second through hole communicating the first mounting chamber with an outside;
a cutting motor provided inside the first mounting chamber, wherein an output shaft of the cutting motor is configured to extend out of the first mounting chamber through the second through hole; and
a cutting structure provided outside the first mounting chamber and connected to the output shaft of the cutting motor.

18. The mowing robot according to claim 17, wherein the cutting mechanism further comprises a height adjustment device; the first mounting seat is movably connected to the connecting seat; the height adjustment device is detachably mounted inside the mounting groove; the first mounting seat is provided at the height adjustment device; the height adjustment device is configured to drive the first mounting seat to move up and down; the height adjustment device comprises:
a second mounting seat, wherein at least a part of the second mounting seat is provided in the mounting groove and detachably fixed to the chassis;
a height adjustment motor provided at the second mounting seat;
a transmission assembly provided at the second mounting seat and connected to the height adjustment motor, wherein the height adjustment motor is configured to drive the transmission assembly; and
a swing arm rotatably provided at the second mounting seat, wherein the swing arm is connected to the transmission assembly; the transmission assembly is configured to drive the swing arm to rotate, and the first mounting seat is provided at the swing arm.

19. The mowing robot according to claim 18, wherein the transmission assembly comprises a screw rod and a gear; the screw rod is in meshing transmission with the gear; the screw rod is connected to the height adjustment motor to drive the gear to rotate; the gear is connected to the swing arm to drive the swing arm to rotate.

20. The mowing robot according to claim 16, wherein the actuator comprises a travelling mechanism; the travelling mechanism comprises a driving wheel module; the chassis is provided with a first mounting compartment; the driving wheel module comprises a travelling motor and a first wheel body driven by the travelling motor; the chassis is further provided with a third through hole communicating the first mounting compartment with the outside; the travelling motor is configured to extend into the first mounting compartment through the third through hole; a first connecting lug is provided at an outer periphery of the travelling motor; a first connecting portion surrounding the first through hole is provided at an outer side of the chassis; the first connecting portion is abutted against the first connecting lug after the travelling motor extends into the first mounting compartment through the first through hole; the first connecting portion is screwed to the first connecting lug by a first fastening element; the first wheel body is provided outside the first mounting compartment.

21. The mowing robot according to claim 20, wherein the chassis and the cover body are enclosed to form a second mounting compartment; a driven wheel module comprises a mounting arm and a second wheel body; the mounting arm having a first end and a second end in a length direction; the cover body is provided with a fourth through hole communicating the second mounting compartment with the outside; the first end extends into the second mounting compartment through the fourth through hole and is detachably connected to the chassis; the second end is provided outside the second mounting compartment and connected to the second wheel body.

22. The mowing robot according to claim 16, wherein the chassis is provided with a collision module, and the collision module comprises:
a support portion fixed to the chassis, wherein the support portion is provided with a detection element electrically connected to the control module; and
a movable cover body, wherein a receiving chamber is formed inside the movable cover body; the support portion is provided inside the receiving chamber, and a movable gap is formed between the support portion and the movable cover body; an elastic member is elastically supported between an inner wall of the receiving chamber and the support portion; the elastic member is configured to allow the movable cover body move relative to the support portion upon a collision, and to return the movable cover body to an original position after the collision disappears; a trigger element is provided at the inner wall of the receiving chamber;
wherein the trigger element is configured to trigger the detection element in response to the trigger element approaching the detection element; the detection element is configured to send a collision signal to the control module in response to the detection element being triggered; the control module is configured to receive the collision signal and control the travelling mechanism to brake based on the collision signal.

23. The mowing robot according to claim 16, wherein the chassis is provided with a battery compartment; the battery compartment is provided with a power supply for supplying power to the actuator and the control module; the power supply is connected with a charger plug configured for charging; the charger plug is connected to the first housing and provided with a charging electrode exposed outside the first housing.
